(19) Europäisches Patentamt
European Patent Office
Office européen des brevets

(11) **EP 0 405 343 B1**

(12) **EUROPÄISCHE PATENTSCHRIFT**

(45) Veröffentlichungstag und Bekanntmachung des Hinweises auf die Patenterteilung:
**07.01.1998  Patentblatt 1998/02**

(51) Int Cl.$^6$: **H01J 37/305**, H01J 37/302

(21) Anmeldenummer: **90111823.2**

(22) Anmeldetag: **22.06.1990**

(54) **Vorrichtung und Verfahren zur Steuerung der verdampften Partikelmenge in einem Verdampfungsprozess**

Apparatus and method for controlling the evaporated particle rate in an evaporation process

Dispositif et procédé de contrôle du taux de particules évaporées dans un procédé d'évaporation

(84) Benannte Vertragsstaaten:
**AT BE CH DE ES FR GB IT LI LU NL SE**

(30) Priorität: **27.06.1989  DE 3921040**

(43) Veröffentlichungstag der Anmeldung:
**02.01.1991  Patentblatt 1991/01**

(73) Patentinhaber: **BALZERS AKTIENGESELLSCHAFT**
**9496 Balzers (LI)**

(72) Erfinder:
 • **Wegmann, Urs**
   **CH-9479 Oberschan (CH)**
 • **Koller, Albert**
   **CH-9477 Trübbach (CH)**

(74) Vertreter: **Troesch, Jacques J., Dr. sc. nat. et al**
**Troesch Scheidegger Werner AG**
**Siewerdtstrasse 95**
**8050 Zürich (CH)**

(56) Entgegenhaltungen:
**EP-A- 0 399 390          US-A- 3 609 378**
**US-A- 4 064 352**

 • **PROCEEDINGS OF THE 8TH INTERNATIONAL VACUUM CONGRESS, Cannes, 22. - 26. September 1980, Band II: "Vacuum Technology and Vacuum Metallurgy", Seiten 542- 545; W.K. HUBER et al.: "Closed loop multi source evaporation rate control with quadrupole mass spectrometer in an ultra high vacuum system"**

Bemerkungen:
Die Akte enthält technische Angaben, die nach dem Eingang der Anmeldung eingereicht wurden und die nicht in dieser Patentschrift enthalten sind.

## Beschreibung

Die vorliegende Erfindung betrifft ein Verfahren sowie eine Anordnung zur Steuerung einer durch einen Strahl geladener Teilchen, insbesondere durch einen Elektronenstrahl von einem Zielobjekt pro Zeiteinheit verdampften Partikelmenge.

Bei der Verdampfung von Zielobjekten mittels Elektronenstrahlen bei Vakuumbeschichtungsprozessen ist es wichtig, die pro Zeiteinheit vom Zielobjekt verdampfte Partikelmenge beeinflussen zu können.

Hierzu ist es aus IEEE Transactions on Magnetics, vol. MAG-11, Nr. 2, March 1975 "Electron Beam Evaporation Synthesis of A15 Superconducting Compounds: Accomplishments and Prospects" von R.H. Hammond, bekannt, an einem Elektronenstrahlerzeuger mit einer beheizten Elektronenemissionselektrode den Massestrom des erzeugten Elektronenstrahls durch Aenderung des Heizstromes an der Emissionselektrode anzusteuern. Mit sich änderndem Massestrom des Elektronenstrahls werden entsprechend sich ändernde Mengen von Partikeln aus dem Zielobjekt, auf welchem der Elektronenstrahl auftritt, verdampft.

Dieses Vorgehen ist in dem Sinne nachteilig, als dass zwischen Anlegen eines geänderten Heizstromes und der Auswirkung bezüglich Massestrom des Elektronenstrahls eine relativ lange Reaktionszeit liegt, d.h. ein solches Steuerglied verhält sich wie ein Tiefpassglied mit hoher Zeitkonstante. Bekanntlich sind aber derartige Glieder insbesondere im Einsatz an Regelkreisen äusserst nachteilig, denn weder kann rasch schnellen Führungssignaländerungen gefolgt werden noch werden höher frequente Störungen ausgeregelt, wenn nicht aufwendige Kompensationsvorkehrungen vorgenommen werden. Regelkreise mit derartigen Stellgliedern sind somit äusserst träge. Im obgenannten Artikel werden Grenzfrequenzen von bis zu 1 Hz angegeben.

Um diesen Nachteil zu beheben, schlägt der obgenannte Artikel weiter vor, die Verweilzeit des Elektronenstrahls an einem Ort des Zielobjekts zu steuern. Dadurch wird der Erhitzungsgrad lokal am Zielobjekt angesteuert. Hierzu ist ein relativ grosser Aufwand erforderlich, um den Elektronenstrahl exakt gesteuert am Zielobjekt hin und her zu verschieben, zudem ist die verdampfte Partikelmenge nicht nur von der Verweilzeit des Elektronenstrahls am einen Ort des Zielobjekts abhängig, sondern auch von der thermischen Vorgeschichte, welche dieser Ort bzw. seine Umgebung erlebt hatten. Durch solche Verweilzeitsteuerungen ergibt sich auch eine unruhige Verdampfung, da der Verdampfungspunkt hin und her bewegt wird. Dabei ist es aber gerade ein Ziel einer beherrschten Ratensteuerung, die Verdampfung möglichst ruhig zu führen.

Die Abhängigkeit zwischen Verweilzeit und verdampfter Partikelmenge ist mithin relativ kompliziert.

Mit diesem Vorgehen, verwendet als Stellverfahren in einem Regelkreis, konnten gemäss obgenanntem Artikel Grenzfrequenzen bis zu 10 Hz erreicht werden.

Im weiteren ist es aus Proceedings of the Eighth International Vacuum Congress, September 22-26, 1980, Cannes, France, Volume II "Vacuum Technology and Vacuum Metallurgy", S. 542 ff, "Closed loop multi source evaporation rate control with a quadrupole mass spectrometer in an ultra high vacuum system" bekannt, die verdampfte Partikelmenge an einem mittels eines Elektronenstrahls verdampften Zielobjekt durch Aenderung der an eine sog. Wehnelt Elektrode angelegten Spannung zu ändern.

Eine Wehnelt Elektrode ist im wesentlichen eine Elektrode mit Lochöffnung, durch welche der Elektronenstrahl durchläuft. Wird ihr elektrisches Potential geändert, so werden die durchlaufenden Elektronen mehr oder weniger radial kraftbeaufschlagt: die Bündelung des Elektronenstrahls wird verändert. Gleichzeitig werden aber axial die Elektronen je nach angelegtem Wehnelt Potential vor Durchlauf durch den Elektrodenring beschleunigt bzw. verzögert, in letzterem Fall ein entsprechender Prozentsatz der emittierten Elektronen zurück gegen die Emissionselektrode reflektiert.

Damit werden mit Veränderung des Potentials der Wehnelt Elektrode sowohl die Strahlbündelung wie auch der Massestrom des Strahls verändert.

Betrachtet man die Wirkung des an die Wehnelt Elektrode angelegten Potentials, beispielsweise Anlegen eines positiven Potentials, so ist ersichtlich, dass dadurch, radial, der Strahl ausgeweitet wird, dass aber gleichzeitig der Strahlmassestrom erhöht wird durch axiale Beschleunigungskräfte im Bereich der Wehnelt Elektrode.

Nun wird aber die Elektronenauftreffdichte pro Flächeneinheit auf dem Zielobjekt durch Aufweiten des Strahls verringert, was zu einer Verringerung der am Zielobjekt verdampften Partikelmenge pro Zeiteinheit führt.

Anderseits wird aber bei erwähnter Wehnelt Spannung der Elektronenstrahlmassestrom erhöht, was offensichtlicherweise die Elektronendichte pro Flächeneinheit am Zielobjekt erhöht. Letzterwähntes erhöht offensichtlicherweise auch die pro Zeiteinheit am Zielobjekt abgetragene Partikelmenge.

Durch Veränderung der Wehnelt Spannung werden somit zwei bezüglich abgetragener Partikelmenge gegenläufige Effekte zwingend gleichzeitig angesteuert. Obwohl die Uebertragungscharakteristik von Aenderung der Strahlbündelung bezüglich angelegter Wehnelt Spannung und Strahlmassestrom bezüglich dieser Spannung unterschiedlich sind, so dass die Wirkungsbilanz schliesslich immer zu einer Aenderung der verdampften Partikelmenge führt, ist die Gesamtübertragung zwischen verdampfter Partikelmenge und angelegter Wehnelt Spannung nicht linear und die Steilheit der Stellcharakteristik nur in einem relativ kleinen Stellbereich zufriedenstellend. Der ausnützbare genähert lineare Stellbereich ist relativ klein.

Daraus ist ersichtlich, dass auch dieses Vorgehen insbesondere wegen seiner Nichtlinearität und möglicher Polstellen der Stellübertragung nur eingeschränkt einsetzbar ist. Aus der US-A-4064352 ist ein Verfahren zur Steuerung eines Strahls gelandener Teilchen, insbesondere eines Elektronenstrahles, bekannt, bei dem die geometrische Lage einer Querschnittsfläche des Strahles gesteuert veränderbar ist. Hierzu läuft der Strahl zwischen ausgedehnten Pohlbacken, wozwischen ein Magnetfeld erzeugt wird, durch. Durch Aenderung dieses Magnetfeldes wird die Lage des Strahles und damit der erwähnten Querschnittsfläche verändert. Im weiteren weist die aus dieser Schrift bekannte Anordnung Zusatzmagnete auf, womit der Flächeninhalt der erwähnten Strahlquerschnittsfläche mittels eines Zusatzmagnetfeldes gesteuert wird. Es werden zwischen zwei Paaren vorgesehener Hilfsmagnete, in Richtung des obgenannten Umlenkfeldes, Zusatzmagnetfelder erzeugt, und zueinander gegenpolig. Bei zu diesen Zusatzmagnetanordnungen symmetrisch liegender Strahlquerschnittsfläche heben sich die umlenkenden Wirkungen der gegenpolig angelegten Zusatzmagnetfelder auf. Hingegen bewirken die durch die jeweiligen Krümmungen dieser Magnetfelder gebildeten Magnetfeldkomponenten quer zum umlenkenden Feld die Strahlquerschnittsfläche aufweiternde bzw. einschnürende Kräfte.

Obwohl es bei diesem Vorgehen möglich ist, den Flächeninhalt der Strahlquerschnittsfläche mit den Hilfsmagnetfeldern zu verändern, ergibt eine Veränderung der geometrischen Lage der Querschnittsfläche mittels der Umlenkfelder zwingend auch eine Aenderung der Strahlquerschnittsfläche, da dann die Strahlquerschnittsfläche in geänderte Krümmungsbereiche der Hilfsmagnetfelder eintritt.

In der nicht vorveröffentlichten EP-0 399 390 ist ein Verfahren beschrieben, mittels welchem die Strahlbündelung von einer Ablenkung des Strahls im wesentlichen nicht beeinflusst wird.

Die vorliegende Erfindung bezweckt, ein Steuerverfahren eingangs genannter Art erfindungsgemäss so auszubilden, dass weitgehendst unabhängig von der Lageverschiebung des Strahles mittels der Strahlquerschnittsfläche die pro Zeiteinheit verdampfte Partikelmenge geführt werden kann.

Dies wird durch Ausführung des Verfahrens nach Anspruch 1 bzw. durch Ausbildung der Anordnung nach Anspruch 17 erreicht.

Damit wird es möglich, an einem in seiner Lage verschieblichen Strahl die pro Zeiteinheit verdampfte Partikelmenge zu stellen, wozu Beheben des Nachteils bezüglich Langsamkeit der Ansteuerung der Partikelmenge durch Ansteuerung thermischer Emissionselektroden wesentlich ist und weiter kein zusätzlicher Aufwand für eine Verweilzeitsteuerung vorgesehen werden muss und womit gegenüber der Partikelmengensteuerung mittels Wehnelt-Spannung der ausnützbare Stellbereich wesentlich erweitert wird.

Wenn nämlich zur Steuerung der verdampften Partikelmenge ausschliesslich die Ausdehnung der Auftrefffläche des Teilchenstrahls auf dem Zielobjekt, wie des oben erwähnten Elektronenstrahls, verändert wird, so verändert sich mit der Flächenausdehnung dieser Auftrefffläche die Temperatur am Zielobjekt und mit der Temperatur die pro Zeiteinheit vom Zielobjekt verdampfte Partikelmenge.

Mit dem erwähnten erfindungsgemässen Steuerverfahren für die verdampfte Partikelmenge pro Zeiteinheit wird ein Regelverfahren für diese Menge geschaffen, welches wegen der hohen Stellsteilheit, der guten Linearisierbarkeit, beides über einen grossen Stellbereich, und der praktisch trägheitslos und damit sehr schnell realisierbaren Ausdehnungsänderung der Auftrefffläche bis zu sehr hohen Frequenzen im kHz-Bereich stabil in regelndem Sinne arbeitet.

Nebst der Steuerung der im obgenannten Sinne von einem Zielobjekt verdampften Partikelmenge ist es des öftern wesentlich, die von einem Zielobjekt verdampfte Partikelmenge bei Vorliegen auch weiterer Partikel selektiv erfassen zu können. Dies wurde bis anhin mittels Massenspektrometern vorgenommen. Waren zwei oder mehr Partikelarten dominant, so wurden entweder zwei oder mehr Massenspektrometer in einem Raumbereich oberhalb des Zielobjektes vorgesehen, je abgestimmt auf die interessierende Partikelart, oder es wurde ein einziger Massenspektrometer vorgesehen und letzterer für die Erfassung beider oder aller Partikelarten hin und her geschaltet oder sukzessive durchgeschaltet.

Bei Weiterbildung der vorliegenden Erfindung gemäss Anspruch 14 ergibt sich ein Verfahren zur selektiven Erfassung der Partikelmenge, die pro Zeiteinheit in einem Raumbereich auftritt, welches wesentlich weniger aufwendig ist als bisher bekannte derartige Verfahren und bessere Ergebnisse bringt, d.h. bei schnellerem Schichtwachstum eine präzise Schichtdickenbeherrschung und homogenere Schichten. Eine derartige Verbesserung führt klar zu einer wesentlichen Erhöhung der Wirtschaftlichkeit von Beschichtungsverfahren bzw. -anlagen.

Dabei wird die Partikelmenge in vorgegebener Art in der Zeit moduliert, beispielsweise mittels einer fixen Trägerfrequenz. Es werden Partikel im Raumbereich erfasst, und es wird durch selektive Demodulation der erfassten Partikelmenge der vom erwähnten Zielobjekt verdampfte Partikelanteil gemessen. Bei der erwähnten Modulation auf einer fixen Modulationsfrequenz, bei der vorzugsweise die Auftrefffläche pulsierend kontrahiert und expandiert wird, wird die erwähnte Demodulation frequenzselektiv auf der erwähnten fixen Trägerfrequenz ausgeführt.

Die pro Zeiteinheit verdampfte Partikelmenge wird dabei beispielsweise durch die modulierte Auftreffflächengrösse verändert, was einer Amplitudenmodulation der erwähnten verdampften Partikelmenge entspricht.

Dabei erlaubt das erfindungsgemässe Steuerverfahren eine Partikelmengenmodulation mit hohen Frequenzen.

Mit dem weitergebildeten Verfahren gemäss Anspruch 14 kann nun das erwähnte Modulations-/Demodulationsverfahren zur selektiven Erfassung einer von einem Zielobjekt herrührenden Partikelmenge als gemessene Regelgrösse eingesetzt werden, so dass beispielsweise bei zwei gleichzeitig verdampften Zielobjekten unterschiedlicher Materialien durch unterschiedliche Modulation und Demodulation je die Regelgrössen erfassbar sind, ohne dass zwei oder mehr Massenspektrometer oder ein umschaltbares Massenspektrometer vorzusehen wären. Wird nämlich ein einziges Massenspektrometer vorgesehen und umgeschaltet zur Erfassung der zwei oder mehr Regelgrössen, so entsteht ein abgetastetes Regelsystem mit einer Grenzfrequenz entsprechend der am Massenspektrometer möglichen Umschaltfrequenz, welche relativ tief ist.

Anstelle eines oder mehrerer Massenspektrometer können nun beliebige, teilweise wesentlich einfachere, nicht massenselektive Teilchensensoren eingesetzt werden, wie Ionisationszellen.

Es ist beim erfindungsgemässen schnellen Verfahren zur Steuerung durchaus möglich, für langsame Aenderungen zusätzlich die Verweilzeit und/oder den Massestrom des Teilchenstrahls anzusteuern. Letzteres wird beispielsweise eingesetzt, um den Arbeitspunkt des Teilchenstrahls zu ändern.

Dabei wird bevorzugterweise auch die erwähnte Modulation durch Modulation der Strahlquerschnittsfläche realisiert, beispielsweise durch Vorgabe einer Modulationsamplitude der Auftrefffläche.

Das obgenannte Verfahren mit Modulation/Demodulation als Aufnahmeverfahren für die Regelgrösse kann möglicherweise auch durch Einsatz der Wehnelt-Spannung zur Modulation der Partikelmenge realisiert werden.

Bevorzugte Ausführungsvarianten des erwähnten erfindungsgemässen Verfahrens sind in den Ansprüchen 2 bis 16 spezifiziert, bevorzugte Varianten der erfindungsgemässen Anordnung in den Ansprüchen 17 bis 31.

Die Erfindung wird anschliessend beispielsweise anhand von Figuren erläutert.

Es zeigen:

Fig. 1    schematisch das erfindungsgemässe Steuerverfahren bzw. eine schematische Darstellung einer Anordnung hierfür,

Fig. 2    schematisch einen erfindungsgemässen Regelkreis, bei welchem die Steuerung gemäss Fig. 1 als Stellverfahren bzw. Stellglied eingesetzt ist,

Fig. 3    wiederum schematisch das erfindungsgemässe Messverfahren für die verdampfte Partikelmenge, bei welchem die abgetragene Partikelmenge auf vorgegebene Art und Weise moduliert wird, bevorzugterweise unter Zuhilfenahme einer Steuerung der Auftreff-Flächenausdehnung des Teilchenstrahls, wie des Elektronenstrahls, bevorzugterweise mit einer Steueranordnung bzw. gemäss einem Steuerverfahren gemäss Fig. 1,

Fig. 4    schematisch die Regelung von zwei gleichzeitig abgetragenen Partikelmengen, bei welchen die Regelgrössenerfassung selektiv aufgrund vorgegebener Modulation der Partikelmenge und entsprechender Demodulation erfolgt, vorzugsweise mit einer Ausdehnungsmodulation, vorzugsweise gemäss Fig. 1, und bei dem vorzugsweise als Stellverfahren der Partikelmenge je auf die Ausdehnung der Teilchenstrahlauftreff-Fläche gegriffen wird,

Fig. 5    eine Darstellung eines bevorzugten Verfahrens zur Aenderung der Ausdehnung eines Teilchenstrahls, wie eines Elektronenstrahls, an den Verfahren bzw. Anordnungen gemäss den Fig.1 bis 4, analog zu Fig. 1 des erfindungsgemässen Vorgehens,

Fig. 6    eine Darstellung erfindungsgemäss bevorzugterweise angesteuerter Flussdichtefeldverhältnisse, bei Betrachtung der Felder gemäss Fig. 5 in x-Richtung,

Fig. 7    eine schematische Aufsicht auf die Verhältnisse gemäss Fig. 5 bei Anlegen von zwei zueinander rechtwinklig stehenden Flussdichtefeldern in einer ersten erfindungsgemässen Polaritätsrelation,

Fig. 8    eine Darstellung analog zu Fig. mit Feldern in einer zweiten erfindungsgemässen Polaritätsrelation,

Fig. 9a    eine schematische Aufsicht auf einen stark umgelenkten Strahl gemäss einer Aufsicht auf die Verhältnisse gemäss Fig. 5 mit einer beispielsweisen Bündelungsänderung des Strahls mittels Feldern gemäss Fig. 7,

Fig. 9b    eine Ansicht auf den gemäss Fig. 9a weitwinklig umgelenkten Strahl gemäss einer sich in y-Richtung gemäss Fig. 5 mit den bei Aenderung einer Bündelung sich ändernden Verhältnissen,

Fig. 10    schematisch das Anordnen von zwei orthogonalen Flussdichtefeldern in Ausbreitungsrichtung des Strahls versetzt,

Fig. 11    schematisch eine erfindungsgemässe Anordnung zur Realisierung der in den Fig. 5 bis 9 dargestellten Verhältnisse,

Fig. 12 eine Anordnung analog zu Fig. 11 bei Vorsehen eines weiträumig wirkenden Umlenkfeldes für den Strahl zur Erzeugung von Umlenkverhältnissen analog den in Fig. 9a und 9b dargestellten,

Fig. 13 schematisch in Aufsicht eine Anordnung gemäss den Fig. 11 oder 12 zur Erzeugung von Feldverhältnissen in Analogie zu den in Fig. 7 dargestellten,

Fig. 14 schematisch eine Anordnung zur Erzeugung orthogonaler Bündelungssteuerfelder gemäss den Fig. 7, 8 und bei axialer Feldversetzung gemäss Fig. 10,

Fig. 15 in perspektivischer Ansicht den Aufbau einer bevorzugten Ausführungsform einer erfindungsgemässen Anordnung, prinzipiell aufgebaut gemäss den Fig. 11 und 12.

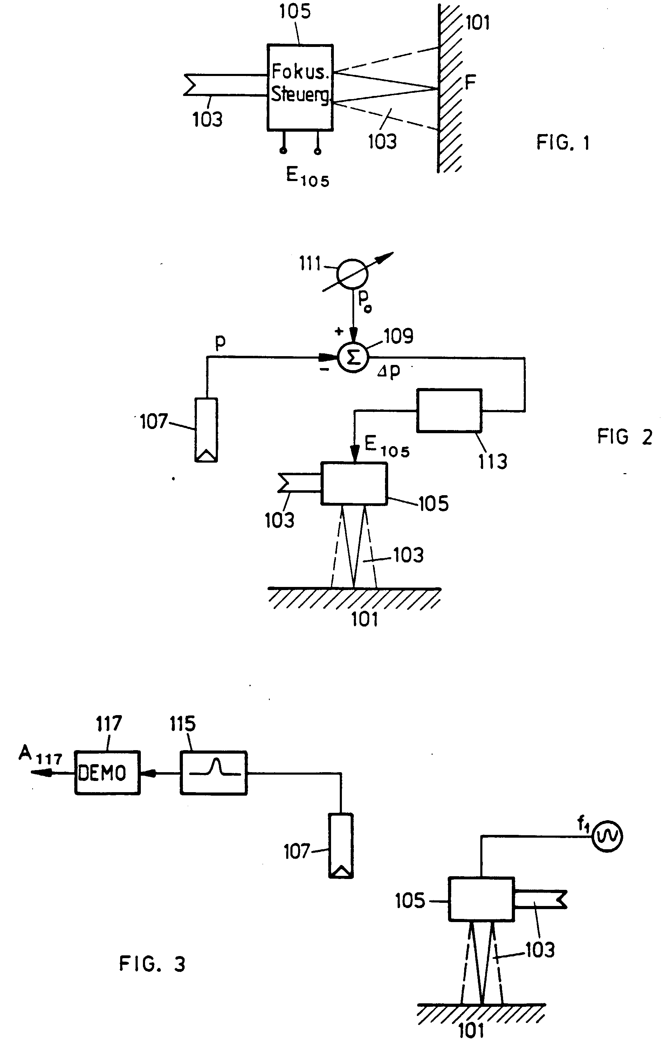

In Fig. 1 ist schematisch eine erfindungsgemässe Anordnung zur Steuerung der pro Zeiteinheit an einem Zielobjekt 101 abgetragenen Partikelmenge pro Zeiteinheit dargestellt. Ein Teilchenstrahl 103, insbesondere ein Elektronenstrahl, wird an einer Fokussierungssteuerung 105 mit Steuereingängen $E_{105}$ in seiner Bündelung nach Durchlaufen der Fokussierungssteuerung 105 gesteuert verändert.

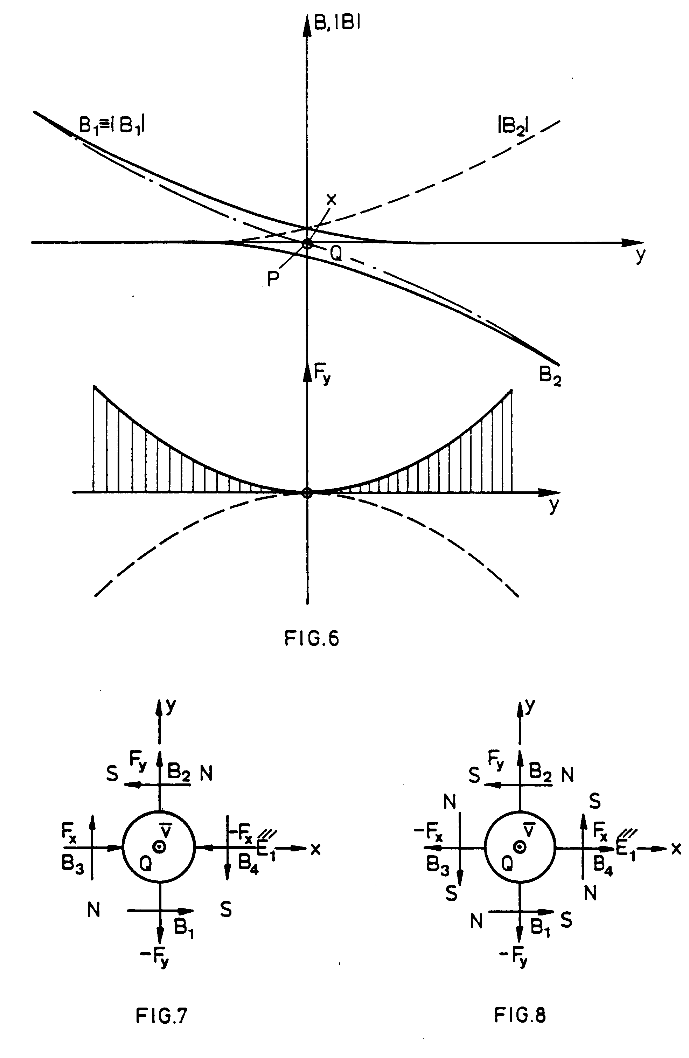

Ein bevorzugter Aufbau einer solchen Fokussierungssteuerung, bei der die Lage der Auftreff-Fläche F, verstanden als die Lage des Schwerpunktes der Fläche F, bei Aenderung der Bündelung unverändert bleibt, ebenso wie der Massestrom des Strahles 103, d.h. die pro Zeiteinheit durch eine betrachtete Fläche durchtretenden Partikel anzeigt, ist in den Fig. 5 ff und der diesbezüglichen Beschreibung beschrieben.

Mit Aenderung der Fokussierung, d.h. der Ausdehnung der Auftreff-Fläche F auf dem Zielobjekt 101, wird die Dichte pro Flächeneinheit auftreffender Strahlteilchen verändert, damit die dem Zielobjekt 101 durch Impulse übermittelte thermische Energie und damit wiederum die aus dem Zielobjekt 101 (nicht dargestellt) verdampfte Partikelmenge. Es wird dadurch mit der Fokussierungssteuerung eine im wesentlichen lineare bzw. in erster Näherung linearisierbare Abhängigkeit zwischen einem Steuerparameter, nämlich dem Steuersignal am Eingang $E_{105}$ und der vom Zielobjekt 101 verdampften Partikelmenge, erzielt. Weitere Strahlparameter werden nicht massgeblich beeinflusst, so der erwähnte Massestrom und die Lage der AuftreffFläche F am Zielobjekt 101.

Da die Fokussierungsänderung an einem Teilchenstrahl 103, insbesondere einem Elektronenstrahl, sehr schnell erfolgen kann, ist der Frequenzgang vornehmlich durch den Aufbau der Fokussierungssteuerung 105 gegeben und erlaubt, mit Tiefpasscharakteristik, Steuerfrequenzen bis zu einigen kHz, im Aufbau gemäss den Fig. 5 ff.

Damit eignet sich das in Fig. 1 schematisch dargestellte Vorgehen ausgezeichnet als Stellverfahren in einem Regelkreis für die vom Zielobjekt 101 verdampfte Partikelmenge.

Dies ist schematisch in Fig. 2 dargestelltl. In einem vorgegebenen Raumbereich ist als Regelgrössenaufnehmer ein Teilchendetektor 107, beispielsweise eine Ionisationszelle (longauge), vorgesehen und erfasst die in diesem Raumbereich auftretende Partikelmenge p, welche vom Zielobjekt 101 verdampft wurde. Das gemessene Regelgrössensignal entsprechend der Partikelmenge p wird an einer Differenzeinheit 109 mit einem an einer einstellbaren Quelle III einstellbaren Sollwert $p_0$ verglichen und die Differenz $\Delta p$ als Regeldifferenz über einen Regler 113 zur Optimierung des Regelkreisfrequenzganges der Fokussierungssteuerung 105, wie sie anhand von Fig. 1 erläutert wurde, zugeführt. Damit ist die Fokussierungssteuerung als Stellglied im in Fig. 2 dargestellten Regelkreis eingesetzt.

In Fig. 3 ist ein Verfahren bzw. eine Vorrichtung zur selektiven Erfassung einer Partikelmenge in einem Raumbereich dargestellt, in welchem neben den zu erfassenden Partikeln noch weitere vorliegen, wie beispielsweise in einem Vakuumbeschichtungsprozess Beschichtungspartikel nebst Edelgaspartikeln. Grundsätzlich wird dabei die vom Zielobjekt 101 abgetragene Partikelmenge in der Zeit moduliert, beispielsweise in der Zeit wird der Abtrag gemäss einer Sinusfunktion mit vorgegebener Frequenz $f_1$ erzeugt. Damit treten am vorgegebenen Raumbereich, an welchem wiederum ein Partikeldetektor 107 an sich nicht partikelselektiver Art vorgesehen ist, eine Partikelmenge detektiert, welche aus einem stationären Anteil, entsprechend dem Anteil nicht interessierender Partikel besteht, und aus einem Anteil, dessen anfallende Menge sinusförmig in der Zeit variiert. Durch anschliessende Filterung mittels eines Bandpassfilters 115, abgestimmt auf die Frequenz $f_1$, sowie Demodulation in einer Demodulationseinheit 117, worin beispielsweise vom Signal mit der Frequenz $f_1$ der Amplitudenwert ermittelt und stationär ausgegeben wird, wird ein Signal $A_{117}$ erhalten, welches der am Detektor 107 anfallenden Partikelmenge des interessierenden Partikels entspricht.

Obwohl auch eine Wehnelt Spannungsmodulation mit der Frequenz $f_1$ zur Steuerung des zur Verdampfung eingesetzten Elektronenstrahls beige zogen werden kann und dabei vom erfindungsgemässen Konzept nicht abgewichen wird, wird vorzugsweise als Steuerglied, welches mit der Frequenz $f_1$ die verdampfte Partikelmenge in der Zeit moduliert, eine Fokussierungssteuerung 105, wie sie anhand von Fig. 1 erläutert wurde, eingesetzt.

Durch Einsatz dieses einfachen Messverfahrens können teure Massenspektrometer ersetzt werden, da die Partikelselektivität aufgrund des Frequenzkriteriums erfolgt. Bei einem solchen einfachen Messverfahren sind ausserdem Drift- und/oder Kalibrationsprobleme besser beherrschbar.

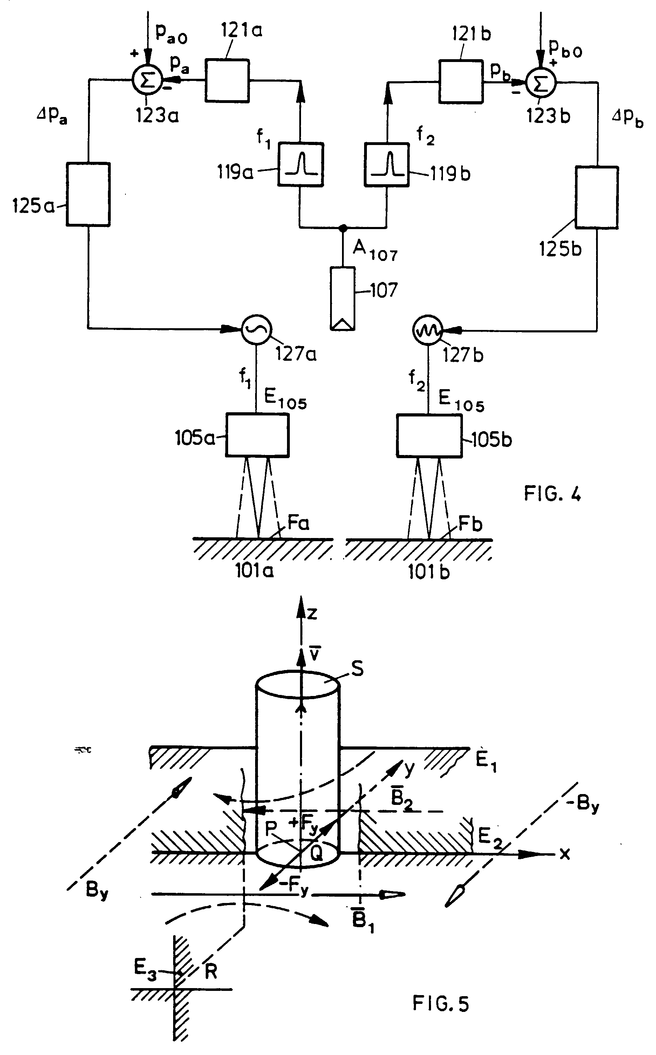

In Fig. 4 ist, ausgehend von den bisherigen Erläuterungen, ein selektiver Regelkreis dargestellt. Mit den Frequenzen $f_1$ und $f_2$ werden grundsätzlich die von den Zielobjekten 101a und 101b verdampften Partikelmengen in der Zeit moduliert. Ein an einem vorgegebenen Raumbereich angeordneter Partikeldetektor 107 detektiert sowohl die vom Zielobjekt 101a abgegebene wie auch die vom Zielobjekt 101b verdampfte Partikelmenge. Sein Ausgangssignal A107 wird selektiv auf den Frequenzen $f_1$ und $f_2$ gefiltert. Die Ausgangssignale der Filtereinheit $119_a$ und $119_b$ je einer Demodulationseinheit 21a bzw. 121b zugeführt. Die Ausgangssignale der Demodulationseinheiten 121 entsprechen den jeweiligen, mit dem Detektor 107 gemessenen selektiven Partikelmengen $p_a$ und $p_b$. Beide werden je auf gemessenes Regelgrössensignal einer Differenzeinheit 123a bzw. 123b zugeführt, wo sie in üblicher Art und Weise mit einem einstellbaren Sollwert $p_{a0}$ bzw. $p_{b0}$ verglichen werden. Die entstehende Regeldifferenz $\Delta p_a$ bzw. $\Delta p_b$ wird über einen entsprechend dimensionierten Regler 125a bzw. 125b dem vorgesehenen Stellglied für die jeweilige Partikelmenge zugeführt. Die Modulationsfrequenzen werden vorzugsweise in fixen Verhältnissen vorgegeben, um Aliasingprobleme zu vermeiden.

Bevorzugterweise, und wie dargestellt, wird nun die Modulation der abgetragenen Partikelmenge in der Zeit an beiden Zielobjekten 101a und 101b mittels einer Fokussierungssteuerung, wie sie anhand von Fig. 1 erläutert wurde, realisiert. Die Modulation wird an den entsprechenden Eingängen $E_{105}$ mittels eines Modulationsgenerators 127a bzw. 127b angesteuert. Dieselben Fokussierungssteuerung 105a und 105b werden aber auch als Stellglieder in diesen Regelkreisen eingesetzt, indem ausgangsseitig die Regler 125a bzw. 125b auf die Modulationsgeneratoren 127a und 127b wirken und daran beispielsweise die Modulationsamplitude verstellen.

Damit werden bei konstant bleibender Frequenz $f_1$ und $f_2$ durch Ansteuerung der Modulation, mit welcher die entsprechenden Auftreff-Flächen $F_a$ bzw. $F_b$ in der Zeit moduliert werden, die jeweiligen, über der Zeit gemittelten verdampften Partikelmengen $p_a$ bzw. $p_b$ verstellt, bis die mit dem Detektor 107 und den jeweiligen frequenzselektiven nachfolgenden Stufen ermittelten Regelgrössenwerte dem vorgegebenen Sollwert $p_{a0}$ bzw. $p_{b0}$ entsprechen.

Anhand der nachfolgenden Figuren wird nun eine bevorzugte Fokussierungssteuerung zum Einsatz mit den Anordnungen bzw. Verfahren, wie sie anhand der Fig. 1 bis 4 erläutert wurden, erklärt.

In Fig. 5 ist die räumliche Anordnung des Strahls monopolar geladener Partikel 5 und der hierzu querstehenden Ebene $E_1$ dargestellt, mit der Strahldurchtrittsfläche Q. Im weiteren ist die Richtung R eingetragen, entlang welcher die Ausdehnung der Strahldurchtrittsfläche Q gesteuert verändert werden soll, sowie die Ebene $E_2$, welche senkrecht zur Ebene $E_1$ und zur Richtung R, der Y-Achse im xyz-Koordinatensystem entsprechend, liegt. Erfindungsgemäss wird nun beidseits der Ebene $E_2$ ein Flussdichtefeld $\bar{B}$ angelegt, mit im wesentlichen parallelem Feidverlauf, wobei auf der einen Seite der Ebene $E_2$ das Flussdichtefeld die eine, auf der anderen Seite die andere Polarität aufweist. Durch die beiden erfindungsgemäss angelegten Flussdichtefelder $\bar{B}_1$ und $\bar{B}_2$ wird, auf die Flächenladung in der Strahldurchtrittsfläche Q, auf einer Seite der Ebene $E_2$ eine Kraft-$F_y$ und auf der anderen Seite dieser Ebene eine Kraft $F_y$ ausgeübt, so dass, je nach Polaritäten der beiden flussdichtefelder $\bar{B}_1$ und $\bar{B}_2$, die Kräfte stauchend oder dehnend auf die genannte Fläche Q wirken.

Sofern die Felder $\bar{B}_1$ und $\bar{B}_2$ entlang der x-Ausdehnung der Fläche Q mindestens im wesentlichen keine Krümmung aufweisen, erfahren die Ladungsträger in der Fläche Q mindestens im wesentlichen keine Kräfte in x-Richtung, und mit Ansteuerung der Feldstärke, d.h. der Beträge der Vektoren $\bar{B}_1$ bzw. $\bar{B}_2$ und deren Polarität, wird die Ausdehnung der Flächenladung Q in Y-Richtung angesteuert, was, bei konstant gehaltener Ausdehnung in x-Richtung, wenn, wie erwähnt, mindestens in diesem Bereich die Feldkrümmung vernachlässigbar ist, dazu führt, dass die Ladungsdichte (Flächenladung) durch Vergrösserung der Fläche Q in y-Richtung verringert wird.

Werden aber, wie gestrichelt eingetragen, die erfindungsgemäss angelegten Flussdichtefelder $\bar{B}_1$ und $\bar{B}_2$ im Bereich der Ausdehnung der Durchtrittsfläche Q gekrümmt erzeugt, so ergeben sich dadurch zur Ebene $E_2$ senkrecht stehende Komponenten $B_y$ bzw. $-B_y$, wie eingetragen, woraus ersichtlich wird, dass auch in diesem Fall übersichtliche Verhältnisse entstehen, indem dann, wenn die Durchtrittsfläche Q in Richtung y gedehnt wird, sie gleichzeitig in Richtung x gestaucht wird und umgekehrt.

Um jedoch Unabhängigkeit von Flächenausdehnungsveränderungen in der einen Richtung, y, von derartigen Veränderungen in der anderen, x, zu erreichen, wird in einer bevorzugten Ausführungsvariante die Bedingung der Parallelität der beiden Flussdichtefelder $\bar{B}_1$ und $\bar{B}_2$ mindestens über einen Bereich, welcher der Ausdehnung der Durchtrittsfläche Q entspricht, erfüllt. Dadurch entstehen bei gesteuerter Veränderung der Flussdichtefelder $\bar{B}_1$ und $\bar{B}_2$ keine Querkomponenten dieser Felder in y-Richtung, womit die Ladungen in der Fläche Q auch nur in y-Richtung kraftbeaufschlagt werden.

Bei der Beurteilung, ob bei der Bündelungssteuerung der Strahl auch eine Ablenkung erfährt oder nicht, ist vorerst zu definieren, wann eine Aenderung der Bündelung als Strahlablenkung zu bezeichnen ist. Es erfährt eine Ladung innerhalb der Strahldurchtrittsfläche Q dort keine Kraft - womit die Bahn einer solchen Ladung bzw. des entsprechenden Partikels unbeeinflusst bleibt - wo sich die erfindungsgemäss angelegten Flussdichtefelder $\bar{B}_1$, $\bar{B}_2$ aufheben. Anderseits kann bereits als Ablenkung bezeichnet werden, wenn sich die Lage des Ladungsschwerpunktes aller in der Ebene $E_1$ momentan auftretenden Ladungen verschiebt. Die Lage des Ladungsschwerpunktes der in der Fläche Q, momentan betrachtet, liegenden Ladungen verändert sich dann nicht, wenn die beiden Flussdichtefelder $\bar{B}_1$ und $\bar{B}_2$ beidseits der zweiten Ebene $E_2$ symmetrisch angelegt werden und diese Symmetrie bei gesteuerter Veränderung der Felder beibehalten wird.

Dies soll anhand von Fig. 6 erläutert werden. In Fig. 6 ist über der Y-Achse, worauf die Ausdehnung der Durchtrittsfläche Q aufgetragen ist, der Effektivwert $B_1$, $B_2$ der beiden Flussdichtefelder $\bar{B}_1$ und $\bar{B}_2$ aufgetragen. Der Verlauf dieser Werte ist rein qualitativ dargestellt und entspricht etwa dem abnehmenden Verlauf mit zunehmender Distanz von einem erzeugenden magnetischen Dipol. Wird die Ebene $E_2$ in den Ladungsschwerpunkt P der Flächenladung über der Fläche Q gelegt und soll dieser Ladungsschwerpunkt P bei Aenderung der Flächenausdehnung in Richtung Y durch die erfindungsgemäss angelegten Flussdichtefelder nicht verändert werden, so werden diese beiden Felder $\bar{B}_1$ und $\bar{B}_2$ so angelegt, dass sie sich in der Ebene $E_2$ aufheben. Der resultierende Verlauf ist qualitativ strichpunktiert dargestellt. Sind nun im weiteren die beiden Flussdichtefelder $\bar{B}_1$ und $\bar{B}_2$ so ausgelegt, dass ihre Beträge /$B_1$/, /$B_2$/ zur Ebene $E_2$ symmetrisch liegen, wie gestrichelt eingetragen, und diese Bedingung auch bei Veränderung der Felder beibehalten, so wird erreicht, dass sich die Felder einerseits und örtlich betrachtet am Ort P weiterhin aufheben, und dass auf die Flächenladung beidseits der Ebene $E_2$ Kräfte gleicher Beträge wirken, womit die Ladungen in der Fläche Q bezüglich der Ebene $E_2$ symmetrisch geänderte Bahnen durchlaufen. Dadurch bleibt der Ladungsschwerpunkt am Ort P, und es erfolgt keine Ablenkung des Strahles. Die wannenartige Verteilung der entstehenden Kräfte $F_y$ ist in Fig. 6 qualitativ dargestellt, gestrichelt bei Polaritätswechsel.

Es ist bekannt, Elektronenstrahlen, als Strahlen geladener Partikel, im Einsatz in Vakuumanlagen in einer gebogenen Bahn vom Strahlerzeuger auf das zu verdampfende Material zu lenken, und zwar teilweise um wesentlich mehr als um 180° bis in den Bereich von 270° oder gar mehr. Um dies realisieren zu können, muss, grundsätzlich wiederum mit einem magnetischen Flussdichtefeld, entlang ausgedehnter Abschnitte der Strahlbahn eingewirkt werden. Dies bedingt des öftern, dass schon kurz nach dem Strahlerzeuger in diesem Sinne umlenkende Flussdichtefelder angelegt werden müssen, um schliesslich die erwünscht grosse Umlenkung zu erzielen. Somit ist es in vielen Fällen nicht möglich, auch aus Gründen einer anzustrebenden kompakten Bauweise einer Elektronenoptik, für die erwähnte Umlenkung und für eine Bündelungssteuerung der hier zur Diskussion stehenden Art, die Umlenkung erst in einem Bahnabschnitt vorzunehmen, derart weit von der Bündelungssteuerung entfernt, dass durch die Umlenkung und deren Veränderung zur Aenderung der Lage der Auftrittsfläche des Strahles auf dem zu verdampfenden Material nicht auch eine Aenderung der Bündelung des Strahls eintritt.

Wie aus Fig. 6 ersichtlich, ergibt sich nämlich dann, wenn durch solche Umlenkmassnahmen die Lage der Fläche Q verändert wird, dass damit die entsprechenden Flächenladungen in sich ändernde Verhältnisse des erfindungsgemäss angelegten Feldes eintreten, womit dann mit der Umlenkung auch Aenderungen der Bündelung auftreten. In Anbetracht dieser Erfordernisse ist es im weiteren öfters wesentlich, den Strahl mindestens in einer Richtung ablenken zu können, ohne dass dabei die Bündelungsverhältnisse ändern. Dies ist bei Betrachten von Fig. 5 ohne weiteres möglich, bei Vorgehen gemäss der vorliegenden Erfindung:

Bei den in Fig. 5 eingetragenen Verhältnissen der beiden erfindungsgemäss angelegten Flussdichtefelder $B_1$ und $B_2$ ist es möglich, den Strahl und damit seine Durchtrittsfläche Q in x-Richtung zu verschieben, ohne dass dabei die erfindungsgemäss angesteuerten Bündelungsänderungen in y-Richtung tangiert würden. Damit wird ersichtlich, dass eine weitere bevorzugte Ausführungsvariante des erfindungsgemässen Verfahrens darin besteht, die Felder beidseits der zweiten Ebene über einen Bereich, der wesentlich länger ist als die Ausdehnung der Durchtrittsfläche Q, konstant anzulegen, und zwar in dem Sinne, dass die Feldverhältnisse im genannten Bereich und fortschreitend in x- oder -x-Richtung unverändert bleiben. Wird nun nämlich beispielsweise für die erwähnte, grosswinklige Strahlumlenkung diese Umlenkung in der Ebene $E_2$ vorgenommen, so kann diese bereits vor dem erfindungsgemässen Ansteuern der Bündelung angegangen werden und zur Aenderung der Auftreff-Flächenlage auch verändert werden, ohne dass dadurch die erfindungsgemäss eingestellte Bündelung beeinflusst würde.

Betrachtet man den Verlauf der Beträge /$B_1$/,/$B_2$/ der angelegten Flussdichtefelder gemäss Fig. 6, so wird ersichtlich, dass dadurch eine dreidimensionale Fläche aufgespannt wird, mit einem in x-Richtung verlaufenden Tal, das beidseits ansteigt.

In manchen Fällen kann es erwünscht sein, die Bündelung des Strahles in mehreren, wie zwei zueinander senkrechten Richtungen, abhängig voneinander oder unabhängig voneinander, ansteuern zu können, d. h. grundsätzlich und gemäss Fig. 5 sowohl in y- wie auch in x-Richtung. Hierzu wird vorgeschlagen, dass man bezüglich einer dritten Ebene, in Fig. 5, $E_3$, welche senkrecht zur ersten, $E_1$, und zur zweiten, $E_2$, steht, und welche die Richtung R enthält, beidseits ein zweites Flussdichtefeld anlegt, mit beidseits parallelen Vektorkomponenten umgekehrter Polarität und vorzugsweise bezüglich der dritten Ebene symmetrischen Beträgen. Ein solches zweites Flussdichtefeld entspricht den bereits in Fig. 5 gestrichelt mit $B_y$ und -$B_y$ eingetragenen Feldern, welche entstehen, wenn, wie oben erläutert wurde, das erste Flussdichtefeld $\bar{B}_1$ bzw. $\bar{B}_2$, wie ebenfalls in Fig. 5 gestrichelt eingetragen, gekrümmt ist.

In Fig. 7 ist, in Aufsicht auf eine Darstellung analog zu Fig. 5, das erste magnetische Flussdichtefeld mit den Anteilen $\bar{B}_1$ und $\bar{B}_2$ gemäss Fig. 5 eingetragen, und das zweite, senkrecht dazu stehende Flussdichtefeld mit den Anteilen $\bar{B}_3$ und $\bar{B}_4$. In der Konstellation gemäss Fig. 7 wechseln sich, wenn man um die Durchtrittsfläche $\bar{Q}$ umläuft, die Polaritäten der Flussdichtefelder B ab. Damit entstehen die ebenfalls in Fig. 7 eingetragenen Kräfteverhältnisse, d.h., wenn die Polaritätsverhältnisse beibehalten werden, wird in der einen der Richtungen, x bzw. y, die Fläche Q gestaucht bzw. gedehnt und in der anderen, y bzw. x, gedehnt bzw. gestaucht. Diese Felder-Polaritätskonstellation kann ohne weiteres durch Vorsehen zweier magnetischer Dipole realisiert werden, wie aus der Polverteilung um die Fläche Q ersichtlich ist.

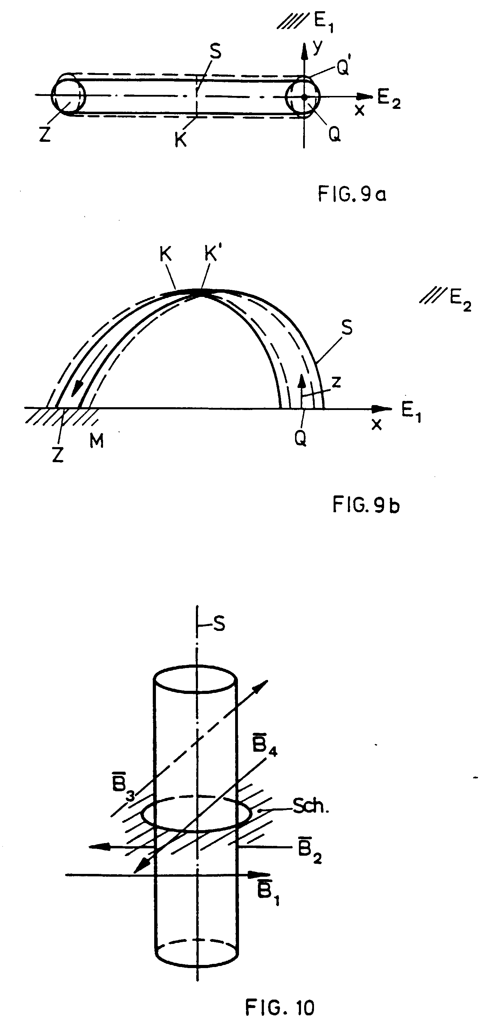

In Fig. 8 ist eine weitere Auslegung der Flussdichtefelder dargestellt, in einer analogen Darstellung zu Fig. 7. Hier wechseln sich, beim Umlaufen um die Durchtrittsfläche Q, die Polaritäten der FlussdichteFeldanteile $\bar{B}_1$ bis $\bar{B}_4$ nicht ab. Bei dieser Konstellation der Polaritäten wirken, wie eingetragen, alle durch die Feldanteile bewirkten Kräfte entweder nach aussen oder nach innen, womit ein zentral-symmetrisches Aufweiten bzw. Konzentrieren der Durchtrittsfläche Q ermöglicht wird. Diese Polaritätskonstellation kann, wie aus den eingetragenen Magnetpolen ohne weiteres ersichtlich, nicht durch zwei magnetische Dipole realisiert werden, und es sind hierzu weitere Vorkehrungen zu treffen, wie anhand von Fig. 10 erläutert werden wird.

Soll durch das angelegte zweite Flussdichtefeld mit den Anteilen $B_3$ und $B_4$ in beiden Polaritätsverteilungen gemäss den Fig. 7 und 8 nur die Bündelung des Strahls entsprechend einer Veränderung seiner Durchtrittsfläche Q in Richtung x bzw. -x beeinflusst werden, so wird dieses zweite Flussdichtefeld, wiederum mindestens auf einer Länge entsprechend der Ausdehnung der Fläche Q in y-Richtung, parallel ausgelegt. Bezüglich der bevorzugten symmetrischen Auslegung der Beträge des zweiten angelegten Flussdichtefeldes gelten die anhand von Fig. 6 für das erste angelegte Flussdichtefeld gemachten Ueberlegungen: Dies ist ein Erfordernis, sofern angestrebt wird, den Ladungsschwerpunkt der in der Fläche Q momentan liegenden Flächenladungen nicht zu verschieben.

Wenn auch das zweite angelegte Flussdichtefeld so angelegt wird, dass die Felder beidseits der dritten Ebene über einen Bereich, der wesentlich länger ist als die Ausdehnung der Durchtrittsfläche Q, konstant sind, so wird gemäss den Fig. 7 und 8 die in x-Richtung bewirkte Aenderung der Bündelung durch das zweite Flussdichtefeld mit den Teilen $\bar{B}_3$ und $\bar{B}_4$ nicht beeinflusst von einer Auslenkung des Strahles in y-Richtung, welche eine örtliche Verschiebung der Durchtrittsfläche Q bewirkt. Die Kombination, dass nämlich die Bündelung in y-Richtung, bewirkt durch das erste Flussdichtefeld $\bar{B}_1$ und $\bar{B}_2$ nicht beeinflusst ist durch eine Verschiebung der Fläche Q bzw. des Strahls in x-Richtung, und dass die Bündelung in x-Richtung, bewirkt durch das zweite Flussdichtefeld mit den Teilen $\bar{B}_3$ und $\bar{B}_4$, nicht beeinflusst ist durch eine Verschiebung der Durchtrittsfläche Q und mithin des Strahls in y-Richtung, wird in manchen Fällen angestrebt, um insbesondere den Abgleich der Bündelungssteuerfelder an einem Arbeitspunkt des Strahls leichter vorzunehmen, um welchen er in x- und y-Richtung nachmals im Betrieb abgelenkt wird.

Die Polaritätsverteilung gemäss Fig. 7 kann in gewissen Anwendungsfällen wesentliche Vorteile aufweisen. Wie erwähnt wurde, ist es in manchen Fällen der Anwendung von Elektronenstrahlen üblich, diese in einer Ebene stark umzulenken. Beim erfindungsgemässen Auslegen des ersten Flussdichtefeldes mit den Anteilen $\bar{B}_1$ und $\bar{B}_2$ gemäss Fig. 5 ist es angezeigt, wie in Fig. 9a in Aufsicht dargestellt, diese Umlenkung des Strahls 5 in der zweiten Ebene $E_2$ vorzunehmen. In Seitenansicht ist in Fig. 9b der Verlauf des Strahls S in der Ebene $E_2$ dargestellt. Bei einer solchen Umlenkung entsteht üblicherweise, wie auch z.B. aus der US-A- 4 064 352 bekannt, in Seitenansicht gemäss Fig. 9b, ein Bereich K, an welchem der Strahl eingeschnürt ist. In Aufsicht, d.h. in der Umlenkungsebene $E_2$, entsteht vielfach eine derartige Einschnürung nicht.

Diese Verhältnisse werden nun beim Vorgehen gemäss Fig. 7 optimal ausgenützt. Wenn gemäss Fig. 7 mit dem ersten Flussdichtefeld $\bar{B}_1$, $\bar{B}_2$ eine Ausdehnung der Querschnittsfläche Q und somit des Strahls in y-Richtung erfolgt, so ergeben sich die in Fig. 9a gestrichelt dargestellten Verhältnisse. Gleichzeitig kann mit dem zweiten angelegten Flussdichtefeld mit den Anteilen $\bar{B}_3$ und $\bar{B}_4$, allenfalls direkt gekoppelt mit dem ersten Flussdichtefeld, eine Stauchung der Durchtrittsfläche Q vorgenommen werden. Es resultieren dabei die in Fig. 9a gestrichelt eingetragenen Querschnittsflächen Q'.

Auf Fig. 9b blickend, ergibt sich aber bei der Reduzierung der Durchtrittsflächenausdehnung Q in x-Richtung eine Verschiebung des Einschnürungsbereiches K z.B. an den Bereich K', d.h. näher zur Strahlquelle hin. Dies entspricht der Verschiebung eines Fokuspunktes näher zur Lichtquelle hin. Damit entsteht auf dem Ziel, beispielsweise dem zu verdampfenden Material M in Richtung x betrachtet, bzw. in der Ebene $E_2$ das Inverse, d.h., wenn in dieser Richtung die Durchtrittsfläche Q gestaucht wird, wird die Auftrittfläche auf dem Material M wegen der Verschiebung des Einschnürungsbereiches K' vergrössert. Damit ist der Vorteil der in Fig. 7 dargestellten Polaritätswahl, insbesondere im Falle grosser Umlenkung des betroffenen Elektronenstrahls S um mehr als 90°, insbesondere mehr als 180°, manifest: Gerade durch diese Polaritätswahl wird die Auftreff-Fläche Z in Fig. 9 radial nach allen Richtungen ausgeweitet oder komprimiert. Die resultierende, qualitative Strahlverteilung ist in Fig. 9b ebenfalls gestrichelt dargestellt. Die Lage des Einschnürungsbereiches im Sinne eines Arbeitspunktes, um den diese Lage durch Aenderung der Bündelung ändert, wird grundsätzlich durch den Strahlerzeuger sowie die elektronenoptischen Massnahmen zur Strahlformung festgelegt.

Während, wie noch zu erläutern sein wird, bei Wahl einer Polaritätskonfiguration gemäss Fig. 8 dies vorzugsweise dadurch realisiert wird, dass das erste Flussdichtefeld $\bar{B}_1$, $\bar{B}_2$ und das zweite Flussdichtefeld $\bar{B}_3$, $\bar{B}_4$ entlang der Strahlachse versetzt angelegt werden, werden bei der Ausführungsvariante gemäss Fig. 7 die beiden Flussdichtefelder im wesentlichen in derselben, der ersten Ebene $E_1$ angelegt.

Soll in der Polaritätskonfiguration gemäss Fig. 7 oder Fig. 8 erreicht werden, dass das erste Flussdichtefeld $\bar{B}_1$, $\bar{B}_2$ unabhängig vom zweiten $\bar{B}_3$, $\bar{B}_4$ und umgekehrt angesteuert werden kann, so wird gemäss Fig. 10 das erste Flussdichtefeld $\bar{B}_1$, $\bar{B}_2$ entlang der Ausbreitung des Strahls 5 versetzt vom zweiten Flussdichtefeld $\bar{B}_3$, $\bar{B}_4$ angelegt. Bevorzugterweise wird zwischen den beiden Flussdichtefeldern eine magnetische Abschirmung SCH vorgesehen, damit sich die beiden Felder nicht gegenseitig beeinflussen. Dieses Vorgehen ist bei der Polaritätswahl gemäss Fig. 8 ohnehin angezeigt. Allerdings kann diese Konfiguration auch durch zeitgestaffelte Erzeugung der Felder $\bar{B}_1$, $\bar{B}_2$ einerseits und $\bar{B}_3$, $\bar{B}_4$ anderseits in der Ebene $E_1$ erfolgen.

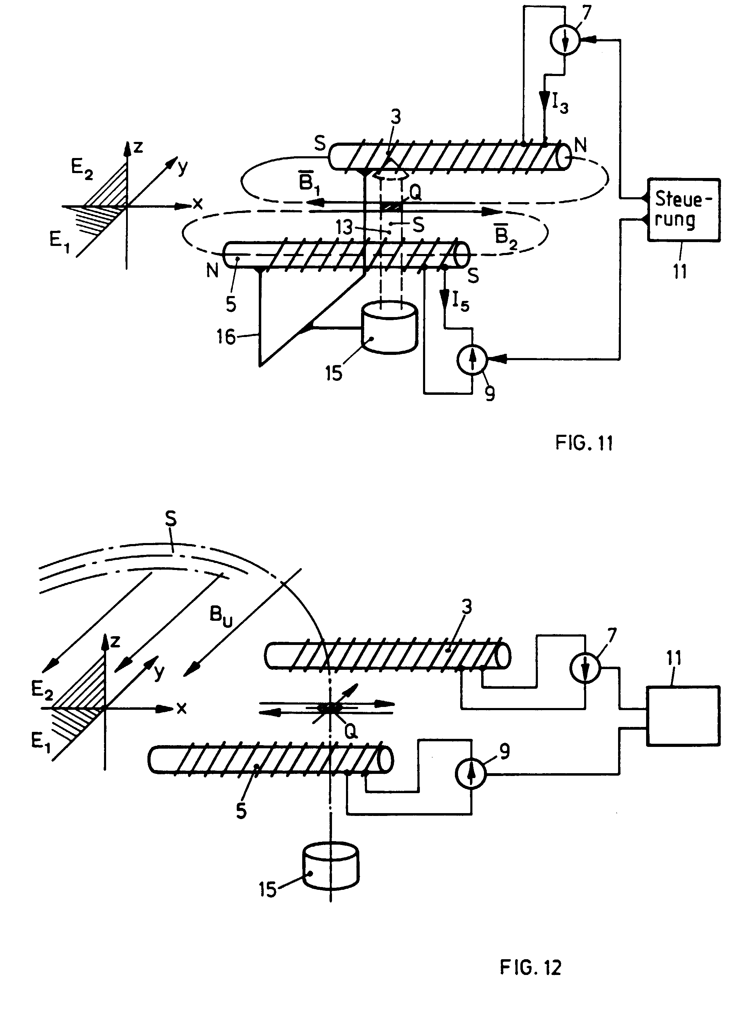

In Fig. 11 ist schematisch und beispielsweise eine erfindungsgemässe Anordnung zur Steuerung der Bündelung dargestellt. Sie umfasst eine Magnetanordnung, die grundsätzlich so ausgebildet ist, dass die Vektorkomponenten des durch die Magnetanordnung erzeugten Flussdichtefeldes, wie anhand von Fig. 5 und 6 erläutert wurde, erzeugt werden. Bevorzugterweise ist die Magnetanordnung durch ein Paar Dipole 3 und 5 gebildet, welche bevorzugterweise durch Elektromagnetanordnungen gebildet werden, je gespiesen über Stromquellen 7 bzw. 9, welche durch eine Steueranordnung 11 angesteuert werden. Die Dipole 3 und 5 können aber auch, wie für Arbeitspunkt-Einstellungen der Bündelung, durch Permanentmagnete gebildet sein oder Permanentmagnete umfassen. An der Anordnung ist ein Bereich 13 definiert, durch welchen der Strahl monopolar geladener Partikel, insbesondere von Elektronen, 5, durchgeschickt wird. Hierzu ist, bezüglich der Dipolanordnung aus den Dipolen 3 und 5, die Lage eines in Fig. 11 schematisch dargestellten Strahlerzeugers 15 festgelegt bzw. festlegbar, wie mit Hilfe einer Fixierungsanordnung für den Strahlerzeuger 15 an bezüglich den Dipolen 3 und 5 definierter Lage. Eine entsprechende Fixierung der Dipole 3, 5 und des Strahlerzeugers 15 ist bei 16 schematisch dargestellt. Wie aus Fig. 11 ersichtlich, werden durch die beiden Dipole 3 und 5 prinzipiell die in Fig. 5 erläuterten Komponenten $\bar{B}_1$ und $\bar{B}_2$ des Flussdichtefeldes erzeugt, ausgelegt bezüglich des Bereiches 13 für den Strahl 5, wie anhand von Fig. 5 bezüglich des Strahles 5 erklärt wurde. Dabei wird in einer bevorzugten Ausführungsvariante angestrebt, beidseits der in Fig. 11 ebenfalls eingetragenen Ebene $E_2$, den Verlauf des Flussdichtefeldes $\bar{B}_1$, $\bar{B}_2$ in einem Bereich, der mindestens dem Durchmesser der Strahldurchtrittsfläche Q entspricht, die durch den durch den Bereich 13 durchlaufenden Strahl 5 gebildet wird, im wesentlichen parallel auszubilden. Wie aus Fig. 11 ohne weiteres ersichtlich, wird dies auf einfache Art und Weise dadurch erreicht, dass die Länge der Dipole 3 bzw. 5, in x-Richtung betrachtet, wesentlich grösser ausgebildet wird als die in x-Richtung betrachtete Ausdehnung der Querschnittsfläche Q des durch den vorgesehenen Bereich 13 durchlaufenden Strahles S.

Mit Hilfe der Steuerung 11 werden die Flussdichtefeldanteile $\bar{B}_1$ und $\bar{B}_2$ beidseits des Durchtrittsbereiches 13 für den Strahl 5, d.h. beidseits der Ebene $E_2$, so angesteuert, dass die Beträge der Flussdichtefelder beidseits dieser Ebene $E_2$ ihrbezüglich symmetrisch sind. Dadurch wird gemäss den Erläuterungen zu Fig. 6 erreicht, dass bei der mit den Flussdichtefeldern $\bar{B}_1$ und $\bar{B}_2$ angesteuerten Veränderung der Strahldurchtrittsfläche Q in y-Richtung der Ladungsschwerpunkt der in der Fläche Q momentan liegenden Flächenladung unverändert bleibt. Die Ansteuerung der Flussdichtefelder $\bar{B}_1$ und $\bar{B}_2$, so, dass diese Bedingung erfüllt ist, erfolgt je nach geometrischer Ausrichtung der beiden magnetischen Dipole 3 und 5 bezüglich der Ebene $E_1$, worin die Durchtrittsfläche Q des Strahles S gezielt beeinflusst werden soll, durch entsprechende Wahl bzw. Ansteuerung der mittels der Stromquellen 7 und 9 erzeugten Ströme.

Um im weiteren zu erreichen, dass die in y-Richtung durch die Magnetanordnungen 3 und 5 bewirkte Steuerung der Strahldurchtrittsfläche Q des durch den Bereich 13 durchlaufenden Strahls über eine relativ grosse Strecke, in x-Richtung betrachtet, unabhängig von der Lage des Strahles 5 in x-Richtung wird, wird weiter die Magnetfeldanordnung, vorzugsweise bestehend aus den zwei Dipolen 3 und 5, so ausgelegt, dass der Verlauf des Flussdichtefeldes $\bar{B}_1$ und $\bar{B}_2$ beidseits der erwähnten zweiten Ebene $E_2$ konstant ist, über einen Bereich, der wesentlich länger ist als die Ausdehnung der Durchtrittsfläche Q des Strahles 5. Dies wird wiederum erreicht durch entsprechend lange Ausdehnung der Magnetdipole 3 bzw. 5, in x-Richtung betrachtet.

Obwohl es durchaus möglich ist, den erfindungsgemässen Flussdichtefeldverlauf gemäss Fig. 5 durch räumliche Ueberlagerung mehrerer Flussdichtefelder zu erzeugen, wird, wie in Fig. 11 dargestellt, bevorzugterweise dieses Feld mittels einer Magnetanordnung erzeugt, die zwei im wesentlichen parallel zur zweiten Ebene angeordnete magnetische Dipole, nämlich die Dipole 3 und 5 aufweist. Diese beiden Dipole brauchen vorerst nicht in der Ebene $E_1$ zu liegen und brauchen ebensowenig bezüglich der Ebene $E_2$ symmetrisch angeordnet zu sein. In weiten Grenzen lässt sich nämlich die geometrische Relatiylage der beiden Dipole 3 und 5 mit Bezug auf den Wirkungsbereich, nämlich den Schnittbereich zwischen den Ebenen $E_1$ und $E_2$, frei wählen und trotzdem der erfindungsgemässe Flussdichtefeldverlauf am Wirkungsbereich durch entsprechende elektrische Ansteuerung der Magnetanordnungen erwirken.

Allerdings müssen dabei allenfalls komplizierte räumliche Feldüberlagerungen berücksichtigt werden. Wenn nicht aus anderen, beispielsweise konstruktiven Randbedingungen erforderlich, wird man deshalb die beiden magnetischen Dipole, wie in Fig. 11 dargestellt, im wesentlichen in die erste Ebene $E_1$ legen. Dann werden die Feldverhältnisse einfach überblickbar. Auch dann brauchen allerdings die beiden Dipole 3 und 5 noch nicht zwingend bezüglich der zweiten Ebene $E_2$ sietrisch zu liegen, und es ist offensichtlich, dass eine Asymmetrie durch entsprechend asymmetrische Ansteuerung oder asymmetrische Wicklungen der Stromquellen 7 bzw. 9 bzw. der Elektromagnete kompensiert werden kann. Wenn nicht wiederum andere Randbedingungen, wie konstruktiver Art mit Bezug auf den Strahlerzeuger 15, dazu zwingen, wird man im weiteren bevorzugterweise und, wie in Fig. 11 dargestellt, die in der ersten Ebene liegenden magnetischen Dipole bezüglich der zweiten Ebene symmetrisch anordnen.

In Fig. 12 sind im wesentlichen Teile der Anordnung gemäss Fig. 11 nochmals aufgezeichnet. Wie erläutert wurde, ist die erfindungsgemässe, durch die beiden Dipole 3 und 5 in y-Richtung bewirkte Bündelungssteuerung des Strahls je nach Auslegung der Dipole, insbesondere je nach ihrer Länge, in x-Richtung weitgehendst unabhängig von der Lage des Strahles in x-Richtung. Wird nun, wie beispielsweise aus der US-A-4 064 352 oder der US-A- 3 420 977 bekannt, der Strahl einer starken Umlenkung unterworfen, und zwar in einem solchen Masse, dass bereits kurz nach Verlassen des Strahlerzeugers, entsprechend 15 in Fig. 12, Umlenkkräfte auf den Strahl ausgeübt werden müssen, um auf vernünftig kurzer Strecke den Strahl ins Ziel zu bringen, so wird vorgeschlagen, eine solche Umlenkung im wesentlichen in der zweiten Ebene vorzunehmen.

Dies ist in Fig. 12 dargestellt, worin die Umlenkeinrichtung, beispielsweise gemäss der US-A-3 420 977, ein Umlenk-Flussdichtefeld $B_U$ erzeugt, welches gemäss Fig. 12 im wesentlichen in y-Richtung verläuft. Dadurch wird, wie gestrichelt dargestellt, der Strahl 5 zunehmend umgelenkt und kann eine Umlenkung bis in den Bereich von 270° oder mehr erfahren. Da eine solche Umlenkeinrichtung mit Erzeugung des Umlenkfeldes $B_U$ unmittelbar nach dem Strahlerzeuger 15 wirksam werden muss, um den Strahl auf möglichst kurzer Strecke, wie erfordert, umzulenken, muss bereits an der erfindungsgemäss vorgesehenen Bündelungssteuerung mit Verschiebungen des Strahls S in x-Richtung gerechnet werden, insbesondere auch wenn die Umlenkung moduliert wird, um den Strahl am Ziel zu verschieben.

Da die erfindungsgemäss bewirkte Steuerung der Bündelung in x-Richtung im wesentlichen unabhängig ist von der Lage des Strahles in dieser Richtung, wird mithin die Umlenkung vorzugsweise in der Ebene $E_2$ vorgenommen.

Anhand der Fig. 7 und 8 sowie 9 wurden vorgängig die Auswirkungen diskutiert, wenn zusätzlich zum erwähnten ersten Flussdichtefeld $\bar{B}_1$, $\bar{B}_2$ senkrecht dazu, ein zweites Flussdichtefeld $\bar{B}_3$, $\bar{B}_4$ angelegt wird.

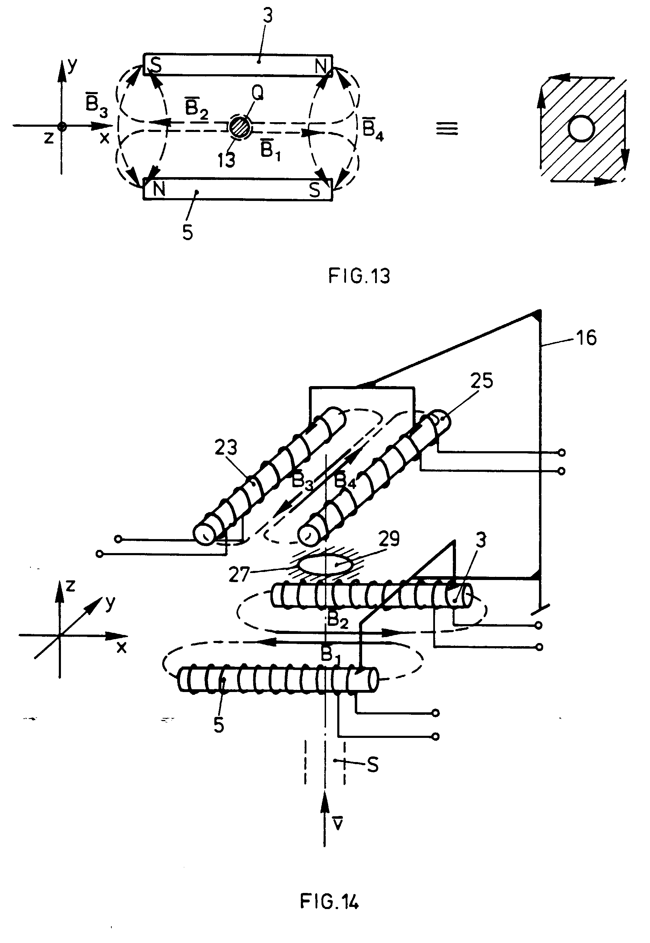

In Fig. 13 ist schematisch in Aufsicht die Anordnung der beiden Dipole 3 und 5 gemäss den Fig. 11 bzw. 12 dargestellt. Je nach Abstand der beiden Dipole 3 und 5, in y-Richtung betrachtet und ihrer Länge in x-Richtung betrachtet, entstehen auch auf dem vorgesehenen Durchtrittsbereich 13 für den Strahl 5 mit seiner Durchtrittsfläche Q wirksame Flussdichtefelder $\bar{B}_3$ und $\bar{B}_4$, wie schematisch in Fig. 7 dargestellt wurde. Damit wird durch entsprechende Dimensionierung der Anordnung mit den Dipolen 3 und 5 die Flussdichtefeldkonfiguration gemäss Fig. 7 mit der dort dargestellten Feldpolung direkt erreicht und mithin die anhand von Fig. 9 diskutierten Vorteile bezüglich Inversion von Zielflächen-Ausdehnungsänderungen bezüglich der Durchtrittsflächen-Ausdehnungsänderung von Q.

Grundsätzlich wird mithin angestrebt, wenn an der Anordnung eine Einrichtung zur Strahlerzeugung sowie der Art einer Elektronenoptik vorgesehen ist (je nach Strahlpartikelart), welche entlang der Strahlausbreitung mindestens einen Einschnürungs-Bereich des Strahls erzeugt, wie anhand von Fig. 9 erläutert wurde, die Magnetanordnung, wie beispielsweise anhand von Fig. 11, 12 oder 13 dargestellt, und die Einrichtung, bei welcher es sich beispielsweise um die in Fig. 12 dargestellte Umlenkungseinrichtung handeln kann sowie um einen Strahlerzeuger bekannter Bauart, so aufeinander abzustimmen, dass sich eine Durchtrittsflächenquerschnittsänderung im Bereich des Einflusses der durch die Magnetanordnung mit den Dipolen 3 und 5 bewirkten magnetischen Flussdichte $\bar{B}_1$ bis $\bar{B}_4$ invers auf eine Durchmesseränderung einer Strahlzielfläche mindestens in eine Richtung auswirkt, wie dies detailliert anhand von Fig. 9 erörtert wurde. Dies wird mit der Anordnung gemäss Fig. 13 bei einer Umlenkungseinrichtung und einem Strahlerzeuger, die einen Einschnürungs-Bereich gemäss Fig. 9b erzeugen, erreicht.

In Fig. 14 ist schematisch eine Magnetanordnung dargestellt, welche es erlaubt, die Flussdichte $\bar{B}_1$, $\bar{B}_2$ und die weitere Flussdichte $\bar{B}_3$, $\bar{B}_4$ senkrecht dazu unabhängig voneinander anzusteuern. Hierzu sind entlang der Ausbreitungsrichtung für den Strahl S einerseits die beiden Dipole 3, 5 vorgesehen und, diesbezüglich entlang der Strahlausbreitungsrichtung versetzt, senkrecht zu den Dipolen 3 und 5, weitere Dipole 23 und 25, welche das Flussdichtefeld $\bar{B}_3$, $\bar{B}_4$ gemäss Fig. 8 oder gemäss Fig. 7 ansteuern. Durch Vorsehen eines magnetischen Schirmes 27 mit einer Durchtrittsöffnung 29 für den Strahl werden die beiden unabhängig voneinander anzusteuernden Flussdichtefelder $\bar{B}_1$, $\bar{B}_2$ und $\bar{B}_3$, $\bar{B}_4$ voneinander weitgehend entkoppelt. Auf diese Art und Weise ist es möglich, den Strahl sowohl in Richtung x, wie auch in Richtung y, unabhängig voneinander in seiner Bündelung zu steuern. Wie schematisch bei 16 dargestellt, werden die beiden Dipolpaare 3, 5, 23 und 25 bezüglich des vorgesehenen Bereiches für den Strahl fixiert.

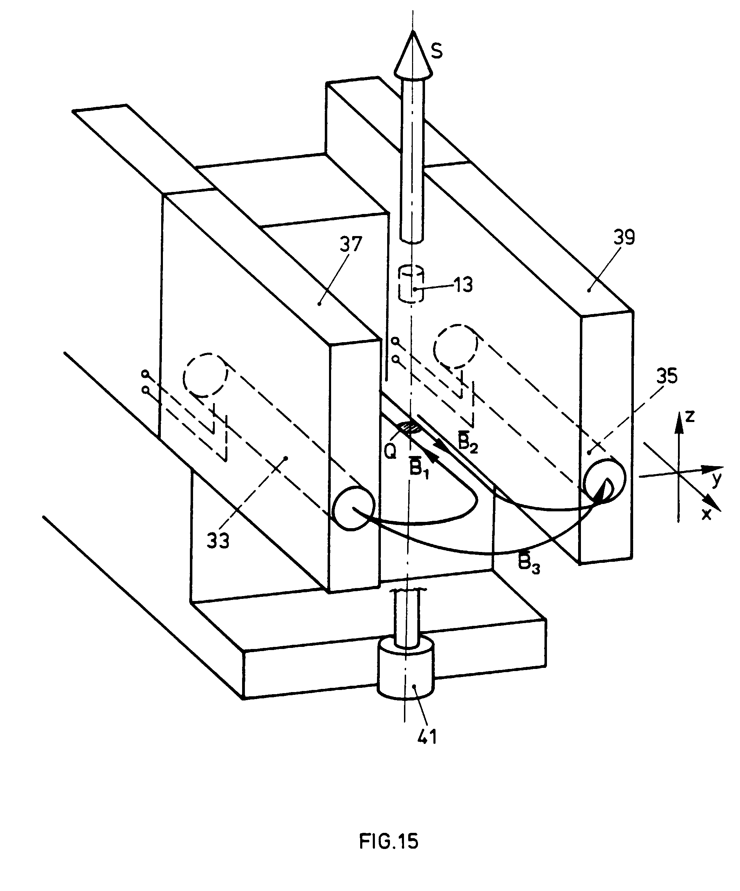

In Fig. 15 ist schematisch ein bevorzugter Aufbau der erfindungsgemässen Anordnung dargestellt. Zwei Elektromagnete 33 und 35, entsprechend den Dipolen 3 und 5 der Fig. 11, 12 oder 13, sind parallel zueinander in je einer backenartigen Halterung 37 bzw. 39 eingebettet. Die Halterungen 37 und 39 sind mindestens im Bereich der Elektromagnete 33, 35 aus nicht ferromagnetischem Material ausgebildet, sind aber, um auch effizient gekühlt werden zu können, bevorzugterweise aus Partien unterschiedlicher Metalle zusammengesetzt, insbesondere aus Partien aus Kupfer und einem rostfreien Stahl.

In schematisch dargestellter Art und Weise ist eine Fixieranordnung für einen Strahlerzeuger 41 vorgesehen, der den Strahl S, insbesondere den Elektronenstrahl, mittig zwischen den Kalterungen 37 und 39 abgibt. Der Feidverlauf mit dem Flussdichtefeld $\bar{B}_1$, $\bar{B}_2$ ist in Fig. 15 beispielsweise eingetragen, ebenso die Wirkung des Querfeldes $\bar{B}_3$.

Mit der erfindungsgemässen Anordnung bzw. den erfindungsgemässen Verfahren wurde ein Stellbereich der Flächenausdehnung des Strahls auf einem Ziel von 1:10 erreicht, z.B. von 5mm bis 50mm Brennfleckdurchmesser, sogar bei einer Strahlumlenkung von ca. 270°. Dies konnte dynamisch bei Stellfrequenzen bis 1kHz erreicht werden. Damit ist es ohne weiteres auch möglich, gegebenenfalls die Bündelung des Strahls zu pulsen.

Im weiteren war es dabei möglich, dank einer weitgehenden Entkopplung von örtlicher Lagesteuerung der Auftreff-Fläche des Strahls auf einem Zielobjekt, bei der erwähnten Umlenkung um ca. 270° auf einer Bahn mit ca. 4 - 5 cm Durchmesser, die Auftreff-Fläche mit einer Frequenz von einigen 100 Hz in einem Raster mit Rasterpunkt-Abstand von ca. 1 - 2 mm über das Zielobjekt zu führen, gleichzeitig die Partikelmenge durch Fokussteuerung mit der erwähnten Stellfrequenz zu steuern.

**Patentansprüche**

1. Verfahren zur Steuerung einer durch einen Strahl (103, S) geladener Teilchen, insbesondere durch einen Elektronenstrahl, von einem Zielobjekt (101) pro Zeiteinheit verdampften Partikelmenge, bei dem

   - die geometrische Lage (x) der Querschnittsfläche (F) des Strahls (103, S) auf dem Zielobjekt (101) gesteuert verändert wird,

   - der Flächeninhalt der Strahlquerschnittsfläche (F) auf dem Zielobjekt mittels eines Magnetfeldes (B) gesteuert wird,

   - zur Steuerung der pro Zeiteinheit verdampften Partikelmenge mittels Vorgabe des Magnetfeldes ($B_1$, $B_2$) die Strahl-Querschnittsflächengrösse eingestellt wird und, im wesentlichen ohne Aenderung des Magnetfeldes ($B_1$, $B_2$) und der dadurch eingestellten Querschnittsflächengrösse, die Lage (x) der Auftrefffläche (F) des Strahls (103, S) auf dem Zielobjekt (101) verändert wird und dabei die verdampfte Partikelmenge als gemessene Regelgrösse (p) erfasst wird und die Querschnittsflächengrösse des Strahls (103, S) als Stellgrösse ($E_{105}$) in einem Regelkreis (107, 109, 111, 105) für die Partikelmenge verändert wird.

2. Verfahren nach Anspruch 1, dadurch gekennzeichnet, dass zur Einstellung des Flächeninhalts der Strahlquerschnittsfläche auf dem Zielobjekt die Ausdehnung einer Strahlquerschnittsfläche (Q) in einer zur Strahlausbreitungsrichtung (z) querstehenden ersten Ebene ($E_1$) mindestens in einer ersten Richtung (R, y) gestellt wird, indem beidseits einer zweiten Ebene ($E_2$) durch die Querschnittsfläche (Q) und senkrecht zur Richtung (R, y) und zur ersten Ebene ($E_1$) ein magnetisches Feld gesteuert angelegt wird, das beidseits der zweiten Ebene ($E_2$) in der ersten Ebene ($E_1$) parallele Vektorkomponenten aufweist, wobei die Vektorkomponenten ($B_1$, $B_2$) beidseits der zweiten Ebene ($E_2$) mit umgekehrter Polarität angelegt werden.

3. Verfahren nach Anspruch 2, dadurch gekennzeichnet, dass man den Feldverlauf im Bereich der Strahlquerschnittsfläche (Q) beidseits der zweiten Ebene ($E_2$) über mindestens eine der Querschnittsflächenausdehnung entsprechende Länge im wesentlichen parallel auslegt, vorzugsweise über einen wesentlich längeren Bereich.

4. Verfahren nach einem der Ansprüche 2 oder 3, dadurch gekennzeichnet, dass man die Felder ($B_1$, $B_2$) beidseits der zweiten Ebene ($E_2$) in ihren Beträgen symmetrisch zur Ebene anlegt und diese Symmetrie bei gesteuerter Veränderung der Felder ($B_1$, $B_2$) beibehält.

5. Verfahren nach einem der Ansprüche 2 bis 4, dadurch gekennzeichnet, dass die Felder ($B_1$, $B_2$) beidseits der zweiten Ebene ($E_2$) über einen Bereich, der wesentlich länger ist als die Ausdehnung der Querschnittsfläche (Q) und der dem Bereich entspricht, worin die geometrische Lage der Querschnittsfläche auf dem Zielobjekt verändert wird, konstant ausgelegt werden.

6. Verfahren nach einem der Ansprüche 2 bis 5, dadurch gekennzeichnet, dass man bezüglich einer dritten Ebene ($E_3$), senkrecht zur ersten ($E_1$) und

zur zweiten ($E_2$) und die Richtung (y) enthaltend, beidseits ein zweites Feld ($B_3$, $B_4$) anlegt, mit beidseits parallelen Vektorkomponenten umgekehrter Polarität und vorzugsweise mit bezüglich der dritten Ebene ($E_3$) symmetrischen Beträgen.

7. Verfahren nach Anspruch 6, dadurch gekennzeichnet, dass man den Feldverlauf des zweiten Feldes, im Bereich der Strahlquerschnittsfläche (Q), beidseits der dritten Ebene, über mindestens eine der Querschnittsflächenausdehnung entsprechende Länge im wesentlichen parallel auslegt.

8. Verfahren nach Anspruch 6, dadurch gekennzeichnet, dass die Felder beidseits der dritten Ebene über einen Bereich, der wesentlich länger ist als die Ausdehnung der Querschnittsfläche, konstant ausgelegt werden.

9. Verfahren nach einem der Ansprüche 6 bis 8, dadurch gekennzeichnet, dass man das zweite Feld ($B_3$, $B_4$) so anlegt, dass, um die Querschnittsfläche (Q) durch die erste Ebene ($E_1$) umlaufend, sich die Polaritäten der Feldvektoren ($B_1$, $B_2$, $B_3$, $B_4$) abwechseln.

10. Verfahren nach einem der Ansprüche 6 bis 9, dadurch gekennzeichnet, dass man das zweite magnetische Feld ($B_3$, $B_4$) im wesentlichen ebenfalls in der esten Ebene ($E_1$) anlegt.

11. Verfahren nach einem der Ansprüche 6 bis 10, dadurch gekennzeichnet, dass man das erste ($B_1$, $B_2$) und das zweite ($B_3$, $B_4$) magnetische Feld, in Strahlausbreitungsrichtung (z), versetzt anlegt und die Felder voneinander entkoppelt, vorzugsweise voneinander abschirmt.

12. Verfahren nach einem der Ansprüche 2 bis 11, dadurch gekennzeichnet, dass man die geometrische Lage der Querschnittsfläche, gesteuert, im wesentlichen parallel zu den Vektoren des magnetischen Feldes ($B_1$, $B_2$) verschiebt.

13. Verfahren nach einem der Ansprüche 2 bis 12, dadurch gekennzeichnet, dass man die Wirkung des einen und/oder beider angelegter magnetischer Felder ($B_1$, $B_2$, $B_3$, $B_4$) auf eine Strahlzielfläche (M) bezüglich der Wirkung auf die Querschnittsfläche (Q) durch räumliches Festlegen mindestens eines Einschnürungsbereiches (K) des Strahls festlegt, wie z.B. invertiert.

14. Verfahren nach einem der Ansprüche 1 bis 13, dadurch gekennzeichnet, dass zur selektiven Erfassung der Partikelmenge die pro Zeiteinheit in einem Raumbereich auftritt, aufgrund der Verdampfung mindestens eines Zielobjekts die am Zielobjekt verdampfte Partikelmenge mit dem Strahl in vorgegebener Art in der Zeit moduliert wird, im Raumbereich die dort vorhandene Partikelmenge erfasst wird und ein der erfassten Partikelmenge zugeordnetes Signal gebildet wird, und letzteres entsprechend der Modulation demoduliert wird.

15. Verfahren nach Anspruch 14, dadurch gekennzeichnet, dass das demodulierte Signal als gemessenes Regelgrössensignal im Regelkreis für die verdampfte Partikelmenge eingesetzt wird.

16. Verfahren nach einem der Ansprüche 14 oder 15, dadurch gekennzeichnet, dass die Modulation der Partikelmenge durch modulierte Steuerung der Strahlquerschnittsfläche erfolgt.

17. Anordnung zur Steuerung der durch einen Strahl (103, S) geladener Teilchen von einem Zielobjekt (101) verdampften Partikelmenge pro Zeiteinheit, insbesondere durch einen Elektronenstrahl, mit einer Steuerung ($B_u$) für die geometrische Lage (x) der Auftrefffläche (F) des Strahls (103, S) auf der Zielfläche (101) sowie einer gesteuerten Magnetanordnung (105, 3, 5), die ein Strahlquerschnittsfläche(Q)-änderndes Magnetfeld ($B_1$, $B_2$) erzeugt, wobei die Magnetanordnung (105, 3, 5) ein Feld ($B_1$, $B_2$) erzeugt, das entlang einer Strecke, die wesentlich grösser ist als die in Richtung dieser Strecke betrachtete Ausdehnung der Strahlquerschnittsfläche (Q) und die mindestens dem Stellbereich für die Steuerung der geometrischen Lage (x) der Auftrefffläche des Strahls entspricht, im wesentlichen konstant ist, und weiter die Steuerung die geometrische Lage (x) der Auftrefffläche (F) verändert, im wesentlichen ohne Beeinflussung der Strahlquerschnittsfläche (Q) bei unverändertem Magnetfeld ($B_1$, $B_2$), dass weiter eine Messeinrichtung (107) zur Messung der verdampften Partikelmenge vorgesehen ist und dass die Magnetfeldanordnung (105, 3, 5) als Stellglied in einem Regelkreis (107, 109, 111, 113, 105) für die Partikelmenge eingesetzt ist.

18. Anordnung zur Steuerung nach Anspruch 17, dadurch gekennzeichnet, dass zusätzlich eine Einheit zur Veränderung des Massestromes des Teilchenstrahls und/oder zur Veränderung der Verweilzeit der Teilchenstrahl-Auftrefffläche an einem Ort des Zielobjektes vorgesehen ist.

19. Anordnung nach einem der Ansprüche 17 oder 18, dadurch gekennzeichnet, dass ein Bereich (13) für den Strahldurchtritt vorgesehen ist und die Magnetanordnung ein magnetisches Feld in einer ersten Ebene ($E_1$) erzeugt, die quer zum Strahlbereich liegt, mit Vektorkomponenten, welche beidseits einer zweiten Ebene ($E_2$) senkrecht zur ersten Ebene ($E_1$) zueinander im wesentlichen parallel sind und umgekehrte Polaritäten aufweisen.

20. Anordnung nach Anspruch 19, dadurch gekennzeichnet, dass die Magnetanordnung (3, 5, 23, 25, 33, 35) so ausgebildet ist, dass der Verlauf des Feldes ($B_1$, $B_2$) beidseits der zweiten Ebene ($E_2$) über mindestens einen der Strahlquerschnittsfläche (Q) entsprechenden Bereich im wesentlichen parallel ist, vorzugsweise über einem wesentlich längeren Bereich.

21. Anordnung nach einem der Ansprüche 19 oder 20, dadurch gekennzeichnet, dass das erzeugte Magnetfeld beidseits der zweiten Ebene ($E_2$) einen diesbezüglich symmetrischen Verlauf seiner Beträge aufweist.

22. Anordnung nach einem der Ansprüche 19 bis 21, dadurch gekennzeichnet, dass die Magnetanordnung zwei im wesentlichen parallel zur zweiten Eben ($E_2$) angeordnete magnetische Dipole (3, 5, 23, 25, 33, 35) aufweist, vorzugsweise gebildet durch Stabmagnete.

23. Anordnung nach Anspruch 22, dadurch gekennzeichnet, dass die beiden magnetischen Dipole (3, 5, 23, 25, 33, 35), vorzugsweise durch Stabmagnete gebildet, im wesentlichen in der ersten Ebene ($E_1$) liegen.

24. Anordnung nach Anspruch 23, dadurch gekennzeichnet, dass die beiden magnetischen Dipole bzw. Stabmagnete (3, 5, 33, 35), bezüglich der zweiten Ebene ($E_2$), symmetrisch angeordnet sind.

25. Anordnung nach einem der Ansprüche 17 bis 24, dadurch gekennzeichnet, dass eine Einrichtung der Art einer Elektronenoptik vorgesehen ist, welche entlang der Strahlausbreitung mindestens einen Einschnürungsbereich (K) des Strahls (S) erzeugt, und dass ein Strahlerzeuger, die Magnetanordnung (3, 5, 23, 25, 33, 35) und die Einrichtung ($B_u$) so aufeinander abgestimmt sind, dass sich die Querschnittsänderung im Bereich des Einflusses des Feldes ($B_1$, $B_2$, $B_3$, $B_4$) invers auf eine Durchmesseränderung der Strahlauftrefffläche auswirkt.

26. Anordnung nach einem der Ansprüche 17 bis 25, dadurch gekennzeichnet, dass die Magnetanordnung zwei Stabmagnete (3, 5, 33, 35) aufweist, welche je in einer von zwei auf Abstand gehaltenen Halterungen (37, 39) angeordnet sind, und dass der Bereich für den Strahl zwischen den Halterungen (37, 39) durchläuft.

27. Anordnung nach einem der Ansprüche 17 bis 26, dadurch gekennzeichnet, dass eine Positionier- und Fixieranordnung für einen Strahlerzeuger (15, 41) vorgesehen ist, derart, dass der erzeugte Strahl (5) durch den vorgegebenen Bereich (13) verläuft.

28. Anordnung nach Anspruch 26, dadurch gekennzeichnet, dass die Halterungen (37, 39) im Bereich der Stabmagnete (33, 35) aus einem weitgehend nicht ferromagnetischen Material bestehen und die Stabmagnete vorzugsweise in den Halterungen (37, 39) vakuumdicht gekapselt sind.

29. Anordnung nach Anspruch 26, dadurch gekennzeichnet, dass die Halterungen aus Partien unterschiedlicher Metalle bestehen, wie aus Kupfer und/oder einem rostfreien Stahl.

30. Anordnung nach einem der Ansprüche 17 bis 29, dadurch gekennzeichnet, dass die Magnetanordnung Permanent- und/oder Elektromagnete umfasst.

31. Anordnung nach einem der Ansprüche 17 bis 30, dadurch gekennzeichnet, dass die gesteuerte Magnetanordnung ein die Strahlquerschnittsfläche (F) modulierendes Magnetfeld erzeugt, die Messeinrichtung einen entsprechend der Strahlquerschnittsflächen-Modulation ausgelegten Demodulator (119) aufweist.

32. Anlage zur Werkstückoberflächenbehandlung mit Verdampfen eines Materials, dadurch gekennzeichnet, dass eine Anordnung nach einem der Ansprüche 17 bis 31 vorgesehen ist.

**Claims**

1. A method of controlling an amount of particles which is evaporated from a target object (101) per unit of time by a charged particle beam (103, S), in particular by an electron beam, in which

   - the geometrical position (x) of the cross-sectional surface (F) of the beam (103, S) on the target object (101) is controlledly varied,
   - the surface area of the beam cross-sectional surface (F) on the target object is controlled by means of a magnetic field (B), and
   - the size of the beam cross-sectional surface is adjusted to control the amount of particles evaporated per unit of time by means of presetting of the magnetic field ($B_1$, $B_2$) and, substantially without a change in the magnetic field ($B_1$, $B_2$) and the size of the cross-sectional surface set thereby, the position (x) of the impingement surface (F) of the beam (103, S) on the target object (101) is varied and thereby the evaporated amount of particles is detected as measured regulated value (p) and the size of the cross-sectional surface of the beam (103, S) is varied as an adjusting value ($E_{105}$) in a regulating circuit (107, 109, 111, 105) for the amount of particles.

2. A method according to claim 1 characterised in that for the purpose of adjusting the surface area of the beam cross-sectional surface on the target object the extent of a beam cross-sectional surface (Q) in a first plane ($E_1$) which is disposed transversely to the beam propagation direction (z) is adjusted at least in a first direction (R, y), by a procedure whereby a magnetic field is controlledly applied on both sides of a second plane ($E_2$) through the cross-sectional surface (Q) and perpendicularly to the direction (R, y) and to the first plane ($E_1$), which magnetic field has vector components which are parallel in the first plane ($E_1$) on both sides of the second plane ($E_2$), wherein the vector components ($B_1$, $B_2$) on both sides of the second plane ($E_2$) are applied with reversed polarities.

3. A method according to claim 2 characterised in that the field configuration in the region of the beam cross-sectional surface (Q) on both sides of the second plane ($E_2$) is substantially parallel over at least a length corresponding to the cross-sectional surface extent, preferably over a substantially longer region.

4. A method according to one of claims 2 and 3 characterised in that the fields ($B_1$, $B_2$) on both sides of the second plane ($E_2$) are applied in terms of their magnitudes symmetrically with respect to the plane and said symmetry is maintained upon a controlled variation of the fields ($B_1$, $B_2$).

5. A method according to one of claims 2 to 4 characterised in that the fields ($B_1$, $B_2$) on both sides of the second plane ($E_2$) are applied to be constant over a region which is substantially longer than the extent of the cross-sectional surface (Q) and which corresponds to the region along which the geometrical position of the cross-sectional surface is varied on the target object.

6. A method according to one of claims 2 to 5 characterised in that with respect to a third plane ($E_3$), perpendicularly to the first ($E_1$) and to the second ($E_2$) and including the direction (y), a second field ($B_3$, $B_4$) is applied on both sides, with vector components which are parallel on both sides, of reversed polarities, and preferably with magnitudes which are symmetrical with respect to the third plane ($E_3$).

7. A method according to claim 6 characterised in that the field configuration of the second field, in the region of the beam cross-sectional surface (Q), on both sides of the third plane, is substantially parallel over at least a length corresponding to the cross-sectional surface extent.

8. A method according to claim 6 characterised in that the fields on both sides of the third plane are arranged to be constant over a region which is substantially longer than the extent of the cross-sectional surface.

9. A method according to one of claims 6 to 8 characterised in that the second field ($B_3$, $B_4$) is so applied that the polarities of the field vectors ($B_1$, $B_2$, $B_3$, $B_4$) alternate, moving around the cross-sectional surface (Q) through the first plane ($E_1$).

10. A method according to one of claims 6 to 9 characterised in that the second magnetic field ($B_3$, $B_4$) is also applied substantially in the first plane ($E_1$).

11. A method according to one of claims 6 to 10 characterised in that the first magnetic field ($B_1$, $B_2$) and the second magnetic field ($B_3$, $B_4$) are applied in displaced relationship in the beam propagation direction (z) and the fields are decoupled from each other and preferably screened from each other.

12. A method according to one of claims 2 to 11 characterised in that the geometrical position of the cross-sectional surface is controlledly moved substantially parallel to the vectors of the magnetic field ($B_1$, $B_2$).

13. A method according to one of claims 2 to 12 characterised in that the action of the one and/or both applied magnetic fields ($B_1$, $B_2$, $B_3$, $B_4$) on a beam target surface (M) is established such as for example inverted with respect to the action on the cross-sectional surface (Q) by spatially establishing at least one beam constriction region (K).

14. A method according to one of claims 1 to 13 characterised in that for the purposes of selective detection of the amount of particles which occurs per unit of time in a spatial region, on the basis of evaporation of at least one target object, the amount of particles evaporated at the target object is modulated with the beam in a predetermined manner in respect of time, in the spatial region the amount of particles present there is detected and a signal associated with the detected amount of particles is formed, and the signal is demodulated in accordance with the modulation.

15. A method according to claim 14 characterised in that the demodulated signal is used as a measured regulated value signal in the regulating circuit for the evaporated amount of particles.

16. A method according to one of claims 14 and 15 characterised in that modulation of the amount of particles is effected by modulated control of the beam cross-sectional surface.

17. An arrangement for controlling the amount of particles evaporated by a charged particle beam (103, S) from a target object (101) per unit of time, in particular by an electron beam, having a control means ($B_u$) for the geometrical position (x) of the impingement surface (F) of the beam (103, S) on the target surface (101), and a controlled magnet arrangement (105, 3, 5) which produces a beam cross-sectional surface(Q)-varying magnetic field ($B_1$, $B_2$), wherein the magnet arrangement (105, 3, 5) produces a field ($B_1$, $B_2$) which is substantially constant along a distance which is substantially greater than the extent of the beam cross-sectional surface (Q) as considered in the direction of said distance and which substantially corresponds at least to the adjustment range for the control means of the geometrical position (x) of the beam impingement surface, and further the control means varies the geometrical position (x) of the impingement surface (F) substantially without influencing the beam cross-sectional surface (Q) at an unchanged magnetic field ($B_1$, $B_2$), moreover there is provided a measuring device (107) for measuring the evaporated amount of particles and the magnetic field arrangement (105, 3, 5) is used as an adjusting member in a regulating circuit (107, 109, 111, 113, 105) for the amount of particles.

18. A control arrangement according to claim 17 characterised in that there is additionally provided a unit for varying the mass flow of the particle beam and/or for varying the residence time of the particle beam impingement surface at a location on the target object.

19. An arrangement according to one of claims 17 and 18 characterised in that there is provided a region (13) for the beam to pass therethrough and the magnet arrangement produces a magnetic field in a first plane ($E_1$) which is disposed transversely with respect to the beam region, with vector components which on both sides of a second plane ($E_2$) perpendicularly to the first plane ($E_1$) are mutually substantially parallel and which are of reversed polarities.

20. An arrangement according to claim 19 characterised in that the magnet arrangement (3, 5, 23, 25, 33, 35) is of such a design that the configuration of the field ($B_1$, $B_2$) on both sides of the second plane ($E_2$) is substantially parallel over at least a region corresponding to the beam cross-sectional surface (Q), preferably over a substantially longer region.

21. An arrangement according to one of claims 19 and 20 characterised in that the magnetic field produced on both sides of the second plane ($E_2$) has a configuration in respect of its magnitudes, which is symmetrical with respect thereto.

22. An arrangement according to one of claims 19 to 21 characterised in that the magnet arrangement has two magnetic dipoles (3, 5, 23, 25, 33, 35) arranged substantially parallel to the second plane ($E_2$), preferably formed by bar magnets.

23. An arrangement according to claim 22 characterised in that the two magnetic dipoles (3, 5, 23, 25, 33, 35), preferably formed by bar magnets, are disposed substantially in the first plane ($E_1$).

24. An arrangement according to claim 23 characterised in that the two magnetic dipoles or bar magnets (3, 5, 33, 35) are arranged symmetrically with respect to the second plane ($E_2$).

25. An arrangement according to one of claims 17 to 24 characterised in that there is provided a device of an electron optics type which along the beam propagation produces at least one beam (S) constriction region (K) and that a beam generator, the magnet arrangement (3, 5, 23, 25, 33, 35) and the device ($B_u$) are so matched to each other that the change in cross-section in the region of the influence of the field ($B_1$, $B_2$, $B_3$, $B_4$) acts inversely on a change in diameter of the beam impingement surface.

26. An arrangement according to one of claims 17 to 25 characterised in that the magnet arrangement has two bar magnets (3, 5, 33, 35) which are each arranged in a respective one of two spaced-apart holders (37, 39) and that the region for the beam passes through between the holders (37, 39).

27. An arrangement according to one of claims 17 to 26 characterised in that there is provided a positioning and fixing arrangement for a beam generator (15, 41) such that the generated beam (5) passes through the predetermined region (13).

28. An arrangement according to claim 26 characterised in that the holders ( 37, 39) in the region of the bar magnets (33, 35) comprise a substantially non-ferromagnetic material and the bar magnets are preferably vacuum-tightly encapsulated in the holders (37, 39).

29. An arrangement according to claim 26 characterised in that the holders comprise parts of different metals such as copper and/or a stainless steel.

30. An arrangement according to one of claims 17 ta 29 characterised in that the magnet arrangement includes permanent and/or electromagnets.

31. An arrangement according to one of claims 17 to 30 characterised in that the controlled magnet arrangement produces a magnetic field for modulating the beam cross-sectional surface (F) and the measuring device has a demodulator (119) designed to correspond to the beam cross-sectional surface modulation effect.

32. An installation for workpiece surface treatment with evaporation of a material characterised in that there is provided an arrangement according to one of claims 17 to 31.

**Revendications**

1. Procédé pour commander une quantité de particules évaporée par unité de temps à l'aide d'un faisceau (103, S) de particules chargées, en particulier à l'aide d'un faisceau d'électrons à partir d'un objet cible (101), selon lequel

   - on modifie de manière commandée la position géométrique (x) de la surface de section (F) du faisceau (103, S) sur l'objet cible (101),
   - on commande la superficie de la surface de section de faisceau (F) sur l'objet cible à l'aide d'un champ magnétique (B),
   - pour commander la quantité de particules évaporée par unité de temps, on règle l'étendue de la superficie de la surface de section du faisceau en prédéfinissant le champ magnétique ($B_1$, $B_2$), et on modifie la position (x) de la surface d'incidence (F) du faisceau (103, S) sur l'objet cible (101) globalement sans modifier le champ magnétique ($B_1$, $B_2$) ni l'étendue de la superficie de surface de section ainsi réglée, la quantité de particules évaporée étant enregistrée comme grandeur réglée mesurée (p) tandis que la dite étendue de la superficie de la surface de section du faisceau (103, S) est modifiée comme grandeur de réglage ($E_{105}$) dans un circuit régulateur (107, 109, 111, 105) pour la quantité de particules.

2. Procédé selon la revendication 1, caractérisé en ce que pour régler la superficie de la surface de section de faisceau sur l'objet cible, on règle au moins dans un premier sens (R, y) l'extension d'une surface de section de faisceau (Q) dans un premier plan ($E_1$) transversal par rapport au sens de propagation (z) du faisceau, en appliquant de façon commandée, des deux côtés d'un deuxième plan ($E_2$) traversant la surface de section (Q) et perpendiculaire au sens (R, y) et au premier plan ($E_1$), un champ magnétique qui présente des composantes vectorielles parallèles dans le premier plan ($E_1$), des deux côtés du deuxième plan ($E_2$), les composantes vectorielles ($B_1$, $B_2$) étant appliquées avec des polarités inverses des deux côtés du deuxième plan ($E_2$).

3. Procédé selon la revendication 2, caractérisé en ce qu'on réalise le tracé du champ dans la zone de la surface de section de faisceau (Q), des deux côtés du deuxième plan ($E_2$), pour qu'il soit globalement parallèle sur au moins une longueur correspondant à l'extension de la surface de section, de préférence sur une zone nettement plus longue.

4. Procédé selon la revendication 2 ou 3, caractérisé en ce qu'on applique les champs ($B_1$, $B_2$) des deux côtés du deuxième plan ($E_2$) avec des valeurs symétriques par rapport au plan, et on conserve cette symétrie lors d'une modification commandée des champs ($B_1$, $B_2$).

5. Procédé selon l'une des revendications 2 à 4, caractérisé en ce que les champs ($B_1$, $B_2$) sont appliqués des deux côtés du deuxième plan ($E_2$) avec une valeur constante sur une zone qui est nettement plus longue que l'extension de la surface de section (Q) et qui correspond à la zone dans laquelle la position géométrique de la surface de section sur l'objet cible est modifiée.

6. Procédé selon l'une des revendications 2 à 5, caractérisé en ce que par rapport à un troisième plan ($E_3$) perpendiculaire au premier ($E_1$) et au deuxième ($E_2$) et contenant le sens (y), on applique des deux côtés un second champ ($B_3$, $B_4$) présentant des deux côtés des composantes vectorielles parallèles de polarités inverses et de préférence des valeurs symétriques par rapport au troisième plan ($E_3$).

7. Procédé selon la revendication 6, caractérisé en ce qu'on réalise le tracé du second champ dans la zone de la surface de section de faisceau (Q), des deux côtés du troisième plan, pour qu'il soit globalement parallèle sur au moins une longueur correspondant à l'extension de la surface de section.

8. Procédé selon la revendication 6, caractérisé en ce que les champs sont appliqués des deux côtés du troisième plan avec une valeur constante sur une zone qui est nettement plus longue que l'extension de la surface de section.

9. Procédé selon l'une des revendications 6 à 8, caractérisé en ce qu'on applique le second champ ($B_3$, $B_4$) de telle sorte que les polarités des vecteurs de champs ($B_1$, $B_2$, $B_3$, $B_4$) alternent autour de la surface de section (Q) à travers le premier plan ($E_1$).

**10.** Procédé selon l'une des revendications 6 à 9, caractérisé en ce qu'on applique le second champ magnétique ($B_3$, $B_4$) globalement dans le premier plan ($E_1$), lui aussi.

**11.** Procédé selon l'une des revendications 6 à 10, caractérisé en ce qu'on applique le premier ($B_1$, $B_2$) et le second ($B_3$, $B_4$) champ magnétique de façon décalée dans le sens d'extension (z) du faisceau, et on découple les champs les uns par rapport aux autres, de préférence grâce à un écran.

**12.** Procédé selon l'une des revendications 2 à 11, caractérisé en ce qu'on déplace de façon commandée la position géométrique de la surface de section globalement parallèlement aux vecteurs du champ magnétique ($B_1$, $B_2$).

**13.** Procédé selon l'une des revendications 2 à 12, caractérisé en ce qu'on fixe l'action exercée par l'un des champs magnétiques et/ou par les deux champs magnétiques appliqués ($B_1$, $B_2$, $B_3$, $B_4$) sur une surface cible de faisceau (M), par exemple en l'inversant, par rapport à l'action sur la surface de section (Q) en fixant dans l'espace au moins une zone de rétrécissement (K) du faisceau.

**14.** Procédé selon l'une des revendications 1 à 13, caractérisé en ce que pour enregistrer sélectivement la quantité de particules qui apparaît par unité de temps dans une zone d'espace en raison de l'évaporation d'au moins un objet cible, la quantité de particules évaporée sur l'objet cible est modulée dans le temps à l'aide du faisceau d'une manière prédéfinie, la quantité de particules présente à cet endroit est enregistrée dans la zone d'espace, un signal associé à la quantité de particules enregistrée est formé et ce signal est démodulé suivant la modulation.

**15.** Procédé selon la revendication 14, caractérisé en ce que le signal démodulé est utilisé dans le circuit régulateur comme signal de grandeur réglée mesuré, pour la quantité de particules évaporée.

**16.** Procédé selon la revendication 14 ou 15, caractérisé en ce que la modulation de la quantité de particules a lieu grâce à une commande modulée de la surface de section de faisceau.

**17.** Dispositif pour commander par unité de temps la quantité de particules évaporée à partir d'un objet cible (101) à l'aide d'un faisceau (103, S) de particules chargées, en particulier à l'aide d'un faisceau d'électrons, comprenant une commande ($B_u$) pour la position géométrique (x) de la surface d'incidence (F) du faisceau (103, S) sur la surface cible (101), et un dispositif magnétique commandé (105, 3, 5) qui génère un champ magnétique ($B_1$, $B_2$) modifiant la surface de section de faisceau (Q), étant précisé que le dispositif magnétique (105, 3, 5) génère un champ ($B_1$, $B_2$) globalement constant sur une distance qui est globalement supérieure à l'extension de la surface de section de faisceau (Q) considérée dans le sens de cette distance et qui correspond au moins à la zone de réglage pour la commande de la position géométrique (x) de la surface d'incidence du faisceau, que la commande modifie la position géométrique (x) de la surface d'incidence (F), globalement sans influencer la surface de section de faisceau (Q), pour un champ magnétique ($B_1$, $B_2$) non modifié, qu'il est prévu par ailleurs un dispositif de mesure (107) pour mesurer la quantité de particules évaporée, et que le dispositif magnétique (105, 3, 5) sert d'élément de réglage dans un circuit régulateur (107, 109, 111, 113, 105) pour la quantité de particules.

**18.** Dispositif de commande selon la revendication 17, caractérisé en ce qu'il est prévu en supplément une unité pour modifier le courant de masse du faisceau de particules et/ou pour modifier le temps de séjour de la surface d'incidence du faisceau de particules à un endroit de l'objet cible.

**19.** Dispositif selon la revendication 17 ou 18, caractérisé en ce qu'il est prévu une zone (13) pour le passage du faisceau, et le dispositif magnétique génère un champ magnétique dans un premier plan ($E_1$) qui est situé transversalement par rapport à la zone du faisceau, avec des composantes vectorielles qui sont globalement parallèles des deux côtés d'un deuxième plan ($E_2$) perpendiculaire au premier plan ($E_1$) et qui présentent des polarités inverses.

**20.** Dispositif selon la revendication 19, caractérisé en ce que le dispositif magnétique (3, 5, 23, 25, 33, 35) est conçu pour que le tracé du champ ($B_1$, $B_2$) soit globalement parallèle des deux côtés du deuxième plan ($E_2$) sur au moins une zone correspondant à la surface de section de faisceau (Q), de préférence sur une zone nettement plus longue.

**21.** Dispositif selon la revendication 19 ou 20, caractérisé en ce que le champ magnétique généré présente des deux côtés du deuxième plan ($E_2$) un tracé dont les valeurs sont symétriques par rapport à celui-ci.

**22.** Dispositif selon l'une des revendications 19 à 21, caractérisé en ce que le dispositif magnétique comporte deux dipôles magnétiques (3, 5, 23, 25, 33, 35) disposés globalement parallèlement au deuxième plan ($E_2$) et formés de préférence par des barreaux magnétiques.

**23.** Dispositif selon la revendication 22, caractérisé en ce que les deux dipôles magnétiques (3, 5, 23, 25, 33, 35), formés de préférence par des barreaux magnétiques, se trouvent globalement dans le premier plan ($E_1$).

**24.** Dispositif selon la revendication 23, caractérisé en ce que les deux dipôles magnétiques ou barreaux magnétiques (3, 5, 33, 35) sont disposés symétriquement par rapport au deuxième plan ($E_2$).

**25.** Dispositif selon l'une des revendications 17 à 24, caractérisé en ce qu'il est prévu un mécanisme du type d'un système optique électronique qui génère au moins une zone de rétrécissement (K) du faisceau (S) le long de l'extension de celui-ci, et en ce qu'un générateur de faisceau, le dispositif magnétique (3, 5, 23, 25, 33, 35) et le mécanisme ($B_u$) sont adaptés les uns aux autres pour que la variation de section dans la zone d'influence du champ ($B_1$, $B_2$, $B_3$, $B_4$) ait une action inverse sur une variation du diamètre de la surface d'incidence du faisceau.

**26.** Dispositif selon l'une des revendications 17 à 25, caractérisé en ce que le dispositif magnétique comporte deux barreaux magnétiques (3, 5, 33, 35) qui sont disposés dans deux supports respectifs (37, 39) espacés l'un de l'autre, et en ce que la zone pour le faisceau passe entre les supports (37, 39).

**27.** Dispositif selon l'une des revendications 17 à 26, caractérisé en ce qu'il est prévu un dispositif de positionnement et de fixation pour un générateur de faisceau (15, 41), de telle sorte que le faisceau généré (5) traverse la zone prédéfinie (13).

**28.** Dispositif selon la revendication 26, caractérisé en ce que les supports (37, 39) prévus dans la zone des barreaux magnétiques (33, 35) se composent d'un matériau largement non ferromagnétique et les barreaux magnétiques sont de préférence blindés de manière étanche au vide dans les supports (37, 39).

**29.** Dispositif selon la revendication 26, caractérisé en ce que les supports se composent de parties en métaux différents comme du cuivre et/ou un acier inoxydable.

**30.** Dispositif selon l'une des revendications 17 à 29, caractérisé en ce que le dispositif magnétique comprend des aimants permanents et/ou des électro-aimants.

**31.** Dispositif selon l'une des revendications 17 à 30, caractérisé en ce que le dispositif magnétique commandé génère un champ magnétique qui module la surface de section de faisceau (F), et le dispositif de mesure comprend un démodulateur (119) conçu suivant la modulation de surface de section de faisceau.

**32.** Installation pour le traitement superficiel de pièces par évaporation d'un matériau, caractérisée en ce qu'il est prévu un dispositif selon l'une des revendications 17 à 31.

FIG. 1

FIG 2

FIG. 3

FIG. 4

FIG. 5

FIG.6

FIG.7

FIG.8

FIG. 9 a

FIG. 9 b

FIG. 10

FIG. 11

FIG. 12

23

FIG.13

FIG.14

FIG.15